# EUROPEAN PATENT APPLICATION

(11) **EP 4 701 389 A1**
(43) Date of publication of application: **25.02.2026**
(21) Application number: 25195620.7
(22) Date of filing: 13.08.2025
(51) Int. Cl.: H10K 59/80, H10K 59/38, H10K 59/40

(54) **LIGHT EMITTING DISPLAY DEVICE**

(30) Priority: 22.08.2024 KR 20240112997
(71) Applicant: LG Display Co., Ltd., Seoul, 07336 (KR)
(72) Inventor: PARK, Je-Beom, 10845 Paju-si (KR); JUNG, Dong-Ryul, 10845 Paju-si (KR); YANG, Ji-Seok, 10845 Paju-si (KR); PARK, Jae-Hyun, 10845 Paju-si (KR)
(74) Representative: Ter Meer Steinmeister & Partner

(57) **Abstract**

A light emitting display device includes a substrate; a light emitting diode on the substrate;a bank surrounding the light emitting diode; a thin film transistor between the substrate and the light emitting diode; an encapsulation layer on the light emitting diode; a color filter layer on the encapsulation layer and corresponding to the light emitting diode; a convex lens on the color filter layer; and a touch electrode layer between the encapsulation layer and the convex lens.

## Description

The present application claims the benefit of and priority to Korean Patent Application No. 10-2024-0112997 filed in the Republic of Korea on August 22, 2024.

### BACKGROUND

### 1. Technical Field

The present disclosure relates to a light emitting display device, and more specifically to, for example, without limitation, a light emitting display device being capable of reducing an ambient light reflection without a brightness decrease and/or a stain defect.

### 2. Description of Related Art

Recently, requirements for flat panel display devices having a small occupied area have increased. Among the flat panel display devices, the technology of a light emitting display device including a light emitting diode is rapidly developing.

The light emitting display device may be classified into an organic light emitting display device and an inorganic light emitting display device.

For example, in the light emitting display device, an organic light emitting diode (OLED) includes a cathode as an electron injection electrode, an anode as a hole injection electrode and an organic light emitting layer, which is disposed between the cathode and the anode. When electrons from the cathode and holes from the anode enter into the organic light emitting layer, the electrons and holes are combined to generate an exciton, and the exciton is transformed from an excited state to a ground state. As a result, the light is emitted from the OLED.

Unlike a liquid crystal display (LCD) device, the light emitting display device does not require a polarization plate. However, in the light emitting display device without the polarization plate, a display quality may be decreased by an ambient light (an external light) reflection. Accordingly, to minimize or reduce the ambient light reflection, the light emitting display device includes a polarization plate at a display surface side.

In the light emitting display device with the polarization plate, the ambient light reflection may be reduced, but a brightness may be decreased by the polarization plate.

The description of related art should not be considered prior art merely because it is mentioned in or associated with this section. The description of related art includes information that describes one or more aspects of the subject technology.

### SUMMARY

There is a need to provide a light emitting display device that substantially obviates one or more of the problems associated with the limitations and disadvantages of the related conventional art.

More specifically, there is a need to provide a light emitting display device being capable of preventing an ambient light reflection increase without a brightness decrease, a stain defect and/or a moiré defect.

At least one of the above objects is solved by the features as set out in the independent claim. Further embodiments are specified in the dependent claims. Additional features and advantages of the present disclosure are set forth in the description which follows, and will be apparent from the description, or evident by practice of the present disclosure. The objectives and other advantages of the present disclosure are realized and attained by the features described herein as well as in the appended drawings.

In one aspect of the present disclosure, a light emitting display device is provided. The light emitting device comprises a substrate; a light emitting diode on the substrate; a bank surrounding the light emitting diode; a thin film transistor between the substrate and the light emitting diode; an encapsulation layer on the light emitting diode; a color filter layer on the encapsulation layer and corresponding to the light emitting diode; a convex lens on the color filter layer; and a touch electrode layer between the encapsulation layer and the convex lens.

The terms "concave" and "convex" may be defined with respect to the substrate, i. e., when viewed from the substrate. The convex lens may curved away from the substrate. The concave lens may be curved towards the substrate. The end of a lens may be also referred to as an edge of the lens. The end of a lens may refer to a boundary of the lens. The convex lens and/or the concave lens may have a hexagonal shape. The ends of a lens may be defined in a width direction of the respective lens. The convex lens and/or the concave lens may each form a honeycomb pattern in a plan view. The convex lens and the concave lens may be shifted against each other in a plan view.

A width of the convex lens and a width of the concave lens may be the same or equal.

The light emitting device may further comprise an encapsulation layer covering the light emitting diode.

The light emitting device may further comprise a color filter layer on the encapsulation layer.

The light emitting device may further comprise a first insulating layer covering the color filter layer. The concave lens may be provided on a surface of the first insulating layer.

The light emitting device may further comprise a second insulating layer covering the first insulating layer. The light emitting device may further comprise a third insulating layer on the convex lens. The convex lens may be provided on a surface of the second insulating layer.

Each of a refractive index of the first insulating layer and a refractive index of the third insulating layer may be greater than a refractive index of the second insulating layer. The refractive index of the second insulating layer may the smallest of the refractive indices of the first insulating layer, the second insulating layer and the third insulating layer.

A difference between the refractive index of the second insulating layer and at least one of the refractive index of the first insulating layer and the refractive index of the third insulating layer may be equal to or less than 0.1.

The concave lens may be provided on a surface of the color filter layer.

The light emitting device may further comprise a second insulating layer which may cover the concave lens. The light emitting device may further comprise a third insulating layer on the convex lens. The convex lens may be provided on a surface of the second insulating layer.

Each of or at least one of a refractive index of the color filter layer and a refractive index of the third insulating layer may be greater than a refractive index of the second insulating layer.

A difference between a refractive index of the second insulating layer and at least one of a refractive index of the color filter layer and a refractive index of the third insulating layer may be equal to or less than 0.1.

The light emitting device may further comprise a black matrix at a boundary of a pixel region of the substrate. The concave lens covers at least a part of the black matrix. The black matrix may be provided between adjacent pixel regions of the substrate.

The light emitting device may further comprise a first pixel region. The light emitting device may further comprise a second pixel region. The concave lens may include a first concave lens in the first pixel region. The concave lens may include a second concave lens in the second pixel region. A ratio of a first depth to a first width in the first concave lens may be smaller than a ratio of a second depth to a second width in the second concave lens.

The light emitting device may further comprise a third pixel region. The concave lens may further include a third concave lens in the third pixel region. A ratio of a third depth to a third width in the third concave lens may be smaller than the ratio of the second depth to the second width in the second concave lens. The ratio of the third depth to the third width in the third concave lens may be equal to or smaller than the ratio of the first depth to the first width in the first concave lens.

The light emitting device may comprise a first pixel region. The light emitting device may comprise a second pixel region. The convex lens may include a first convex lens in the first pixel region. The convex lens may include a second convex lens in the second pixel region. A ratio of a first depth to a first width in the first convex lens may be smaller than a ratio of a second depth to a second width in the second convex lens.

The light emitting device may further comprise a third pixel region. The convex lens may further include a third convex lens in the third pixel region. A ratio of a third depth to a third width in the third convex lens may be smaller than the ratio of the second depth to the second width in the second convex lens. The ratio of the third depth to the third width in the third convex lens may be equal to or smaller than the ratio of the first depth to the first width in the first convex lens.

The convex lens may include a plurality of convex lenses. The concave lens may include a plurality of concave lenses. The plurality of convex lenses may partially overlap the plurality of concave lenses.

The light emitting device may comprise a plurality of pixel regions. Each pixel region may include an emission area and a non-emission area. The convex lens may have an area corresponding to the emission area and the non-emission area. The concave lens have an area corresponding to the emission area. In other words, the convex lens may overlap both the emission area and the non-emission area, ideally completely overlap the emission area and the non-emission area. The concave lens may overlap the emission area. The concave lens may only partially overlap the non-emission area at a boundary surrounding the respective emission area.

A ratio of a depth to a width in the convex lens may be different from a ratio of a depth to a width in the concave lens.

The light emitting device may further comprise a thin film transistor between the substrate and the light emitting diode. The light emitting device may further comprise a touch electrode layer between the encapsulation layer and the concave lens.

Other systems, methods, features and advantages will be, or will become, apparent to one with skill in the art upon examination of the following figures and detailed description. Further aspects and advantages are discussed below in conjunction with embodiments of the disclosure.

It is to be understood that both the foregoing general description and the following detailed description are examples and explanatory and are intended to further explain the present disclosure as claimed.

### BRIEF DESCRIPTION OF THE DRAWINGS

The accompanying drawings, which are included to provide a further understanding of the present disclosure, are incorporated in and constitute a part of this present disclosure, illustrate aspects and embodiments of the present disclosure, and together with the description serve to explain principles and examples of the disclosure.
FIG. 1 is a schematic circuit diagram of a light emitting display device of the present disclosure.
FIG. 2 is a schematic cross-sectional view illustrating a light emitting display device according to a first embodiment of the present disclosure.
FIG. 3 is a schematic cross-sectional view illustrating a light emitting display device according to a second embodiment of the present disclosure.
FIG. 4 is a schematic cross-sectional view illustrating a light emitting display device according to a third embodiment of the present disclosure.
FIG. 5 is a schematic plan view showing a convex lens and a concave lens of the light emitting display device according to the third embodiment of the present disclosure.
FIG. 6 is a schematic cross-sectional view illustrating a light emitting display device according to a fourth embodiment of the present disclosure.
FIGs. 7A to 7C are a schematic plan view showing a convex lens and a concave lens in first to third pixel regions of the light emitting display device according to the fourth embodiment of the present disclosure, respectively.
FIG. 8 is a schematic cross-sectional view illustrating a light emitting display device according to a fifth embodiment of the present disclosure.
FIGs. 9A to 9C are a schematic plan view showing a convex lens and a concave lens in first to third pixel regions of the light emitting display device according to the fifth embodiment of the present disclosure, respectively.
FIG. 10 is a schematic cross-sectional view illustrating a light emitting display device according to a sixth embodiment of the present disclosure.
FIG. 11 is a schematic cross-sectional view illustrating a light emitting display device according to a seventh embodiment of the present disclosure.
FIG. 12 is a schematic cross-sectional view illustrating a light emitting display device according to an eighth embodiment of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION

Reference will now be made in detail to aspects of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations are selected only for convenience of writing the specification and may be thus different from those used in actual products.

Advantages and features of the present disclosure and methods of achieving them will be apparent with reference to the aspects described below in detail with the accompanying drawings. The present disclosure is provided to fully inform the scope of the disclosure to the skilled in the art of the present disclosure.

The shapes, sizes, proportions, angles, numbers, and the like disclosed in the drawings for explaining the aspects of the present disclosure are illustrative, and the present disclosure is not limited to the illustrated matters. The same reference numerals refer to the same elements throughout the specification. In addition, in describing the present disclosure, if it is determined that a detailed description of the related known technology unnecessarily obscure the subject matter of the present disclosure, the detailed description thereof can be omitted. When "including," "having," "consisting," and the like are used in this specification, other parts may be added unless "only" is used. When a component is expressed in the singular, cases including the plural are included unless specific statement is described. For example, an element may be one or more elements. An element may include a plurality of elements. The word "exemplary" is used to mean serving as an example or illustration. Embodiments are example embodiments. Aspects are example aspects. In one or more implementations, "embodiments," "examples," "aspects," and the like should not be construed to be preferred or advantageous over other implementations. An embodiment, an example, an example embodiment, an aspect, or the like may refer to one or more embodiments, one or more examples, one or more example embodiments, one or more aspects, or the like, unless stated otherwise. Further, the term "may" encompasses all the meanings of the term "can."

Any implementation described herein as an "example" is not necessarily to be construed as preferred or advantageous over other implementations.

The expression "at least one of a, b, and c" described throughout the specification can encompass "a alone," "b alone," "c alone," "a and b," "a and c," "b and c," or "all of a, b, and c." The advantages and features of the present disclosure, and the methods for achieving them, will become apparent by referring to the embodiments described in detail below together with the accompanying drawings.

In construing an element, the element is construed as including an error or tolerance range although there is no explicit description of such an error or tolerance range.

In describing a position relationship, for example, when a position relation between two parts is described as, for example, "on," "over," "under," and "next," one or more other parts may be disposed between the two parts unless a more limiting term, such as "just" or "direct(ly)" is used.

In describing a time relationship, for example, when the temporal order is described as, for example, "after," "subsequent," "next," and "before," a case that is not continuous may be included unless a more limiting term, such as "just," "immediate(ly)," or "direct(ly)" is used.

The area, length, or thickness of each component described in the specification is illustrated for convenience of explanation, and the present disclosure is not necessarily limited to the area and thickness of the illustrated component.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

Also, when an element or layer is "connected," "coupled," or "adhered" to another element or layer, the element or layer can not only be directly connected or adhered to another element or layer, but also be indirectly connected or adhered to another element or layer with one or more intervening elements or layers "disposed" or "interposed" between the elements or layers, unless otherwise specified. It should be understood to mean that elements may be so disposed to directly contact each other, or may be so disposed without directly contacting each other.

The expression of a first element, a second elements "and/or" a third element should be understood as one of the first, second and third elements or as any or all combinations of the first, second and third elements. By way of example, A, B and/or C can refer to only A; only B; only C; any or some combination of A, B, and C; or all of A, B, and C.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Rather, these embodiments may be provided so that this disclosure may be sufficiently thorough and complete to assist those skilled in the art to fully understand the scope of the present disclosure. Furthermore, the present disclosure is only defined by scopes of claims.

Features of various aspects of the present disclosure may be partially or overall coupled to or combined with each other, and may be variously inter-operated with each other and driven technically as those skilled in the art can sufficiently understand. The aspects of the present disclosure may be carried out independently from each other, or may be carried out together in co-dependent relationship.

Without specific description, a transistor constituting the pixel circuit of the present disclosure may include at least one of an oxide thin film transistor (Oxide TFT), an amorphous silicon TFT (a-Si TFT), and a low temperature poly silicon (LTPS) TFT.

The following embodiments are described with reference to organic light emitting display devices. However, the embodiment of the present disclosure is not limited to organic light emitting display devices. For example, a display device according to an embodiment of the present disclosure may be an organic light emitting display device using an organic light emitting material or an inorganic light emitting display device using an inorganic light emitting material such as a quantum dot.

Reference will now be made in detail to some of the examples and preferred embodiments, which are illustrated in the accompanying drawings.

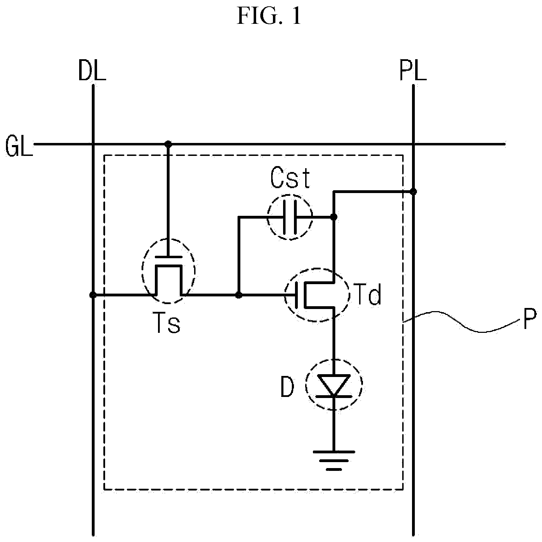

FIG. 1 is a schematic circuit diagram of a light emitting display device of the present disclosure.

As shown in FIG. 1, a light emitting display device includes a gate line GL, a data line DL, a power line PL, a switching thin film transistor TFT Ts, a driving TFT Td, a storage capacitor Cst, and an light emitting diode D. The gate line GL and the data line DL cross each other to define a pixel region P. The switching TFT Ts, the driving TFT Td, the storage capacitor Cst, and the light emitting diode D are disposed in the pixel region P. The pixel region may include a red pixel region, a green pixel region and a blue pixel region.

The switching TFT Ts is connected to the gate line GL and the data line DL, and the driving TFT Td and the storage capacitor Cst are connected to the switching TFT Ts and the power line PL. The light emitting diode D is connected to the driving TFT Td.

In the light emitting display device, when the switching TFT Ts is turned on by a gate signal applied through the gate line GL, a data signal from the data line DL is applied to the gate electrode of the driving TFT Td and an electrode of the storage capacitor Cst.

When the driving TFT Td is turned on by the data signal, an electric current is supplied to the light emitting diode D from the power line PL. As a result, the light emitting diode D emits light. In this case, when the driving TFT Td is turned on, a level of an electric current applied from the power line PL to the light emitting diode D is determined such that the light emitting diode D can produce a gray scale.

The storage capacitor Cst serves to maintain the voltage of the gate electrode of the driving TFT Td when the switching TFT Ts is turned off. Accordingly, even if the switching TFT Ts is turned off, a level of an electric current applied from the power line PL to the light emitting diode D is maintained to next frame.

As a result, the light emitting display device displays a desired image.

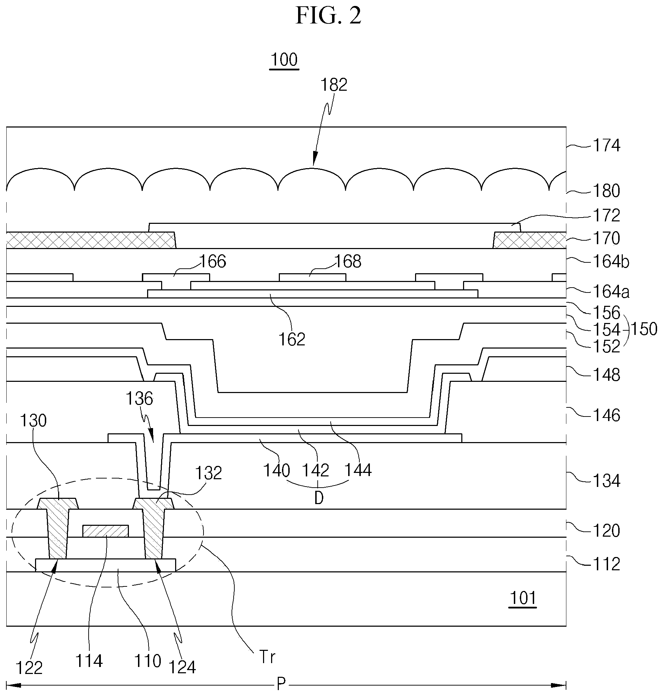

FIG. 2 is a schematic cross-sectional view illustrating a light emitting display device according to a first embodiment of the present disclosure.

As shown in FIG. 2, a light emitting display device 100 includes a substrate 101, a light emitting diode D over the substrate 101, a color filter layer 172 over the light emitting diode D and a convex lens 182 on the color filter layer 172.

A pixel region P including red, green and blue pixel regions is defined on the substrate 101. In addition, the pixel region P may further include a white pixel region.

The substrate 101 may be a glass substrate or a flexible substrate. For example, the flexible substrate may be one of a polyimide (PI) substrate, a polyethersulfone (PES) substrate, a polyethylenenaphthalate (PEN) substrate, a polyethylene Terephthalate (PET) substrate and a polycarbonate (PC) substrate.

A thin film transistor (TFT) Tr is disposed on the substrate 101. In FIG. 2, the TFT is disposed directly on the substrate 101. Alternatively, a buffer layer may be disposed on the substrate 101, and the TFT may be disposed on the buffer layer. The buffer layer may be formed of an inorganic insulating material, e.g., silicon oxide or silicon nitride.

The TFT Tr includes a semiconductor layer 110, a gate electrode 114, a source electrode 130 and a drain electrode 132. The TFT Tr may be a driving TFT.

A semiconductor layer 110 is disposed on the substrate 101. The semiconductor layer 110 may include an oxide semiconductor material. When the semiconductor layer 110 includes the oxide semiconductor material, a light-shielding pattern (not shown) may be disposed under the semiconductor layer 110. The light to the semiconductor layer 110 can be shielded or blocked by the light-shielding pattern such that thermal degradation of the semiconductor layer 110 can be prevented. Alternatively, the semiconductor layer 110 may include polycrystalline silicon. In this case, impurities may be doped into both sides of the semiconductor layer 110.

A gate insulating layer 112 is formed on the semiconductor layer 110 and over an entire surface of the substrate 101. The gate insulating layer 112 may be formed of an inorganic insulating material such as silicon oxide (SiOx) or silicon nitride (SiNx).

A gate electrode 114, which is formed of a conductive material, e.g., metal, is formed on the gate insulating layer 112. The gate electrode 114 corresponds to a center of the semiconductor layer 110. For example, the gate electrode 114 may be formed of one of copper (Cu), molybdenum (Mo), titanium (Ti), aluminum (Al), gold (Au) and silver (Ag). The gate electrode 114 may have a single-layered structure or a multi-layered structure.

In FIG. 2, the gate insulating layer 112 is formed on an entire surface of the substrate 101. Alternatively, the gate insulating layer 112 may be patterned to have the same shape as the gate electrode 114.

An interlayer insulating layer 120, which is formed of an insulating material, is formed on the gate electrode 114 and over an entire surface of the substrate 101. The interlayer insulating layer 120 may be formed of an inorganic insulating material, e.g., silicon oxide or silicon nitride, or an organic insulating material, e.g., benzocyclobutene or photo-acryl.

The interlayer insulating layer 120 includes first and second contact holes 122 and 124 exposing both sides of the semiconductor layer 110. The first and second contact holes 122 and 124 are positioned at both sides of the gate electrode 114 to be spaced apart from the gate electrode 114.

In FIG. 2, the first and second contact holes 122 and 124 are formed through the interlayer insulating layer 120 and the gate insulating layer 112. Alternatively, when the gate insulating layer 112 is patterned to have the same shape as each of the gate electrode 114, the first and second contact holes 122 and 124 are formed only through the interlayer insulating layer 120.

A source electrode 130 and a drain electrode 132, which are formed of a conductive material, e.g., metal, are formed on the interlayer insulating layer 120. The source electrode 130 and the drain electrode 132 are spaced apart from each other with respect to the gate electrode 114 and respectively contact both sides of the semiconductor layer 110 through the first and second contact holes 122 and 124.

For example, each of the source and drain electrodes 130 and 132 may be formed of one of Cu, Mo, Ti, Al, Au and Ag. Each of the source and drain electrodes 130 and 132 may have a single-layered structure or a multi-layered structure.

In FIG. 2, the gate electrode 114, the source electrode 130 and the drain electrode 132 are positioned over the semiconductor layer 110. Namely, the TFT Tr has a coplanar structure. Alternatively, in the TFT Tr, the gate electrode may be positioned under the semiconductor layer, and the source and drain electrodes may be positioned over the semiconductor layer such that each of the TFT Tr may have an inverted staggered structure. In this instance, the semiconductor layer may include amorphous silicon.

Although not shown, the gate line and the data line cross each other to define the pixel region, and the switching TFT is formed to be connected to the gate and data lines. The switching TFT is connected to the TFT Tr as the driving element. In addition, the power line, which may be formed to be parallel to and spaced apart from one of the gate and data lines, and the storage capacitor for maintaining the voltage of the gate electrode of the TFT Tr in one frame may be further formed.

A planarization layer 134 is formed on the source and drain electrodes 130 and 132 and over an entire surface of the substrate 101. Namely, the planarization layer 134 is formed to cover the TFT Tr.

The planarization layer 134 has a flat top surface and includes a drain contact hole 136 exposing the drain electrode 132 of the TFT Tr. The planarization layer 134 can be formed of an inorganic insulating material, e.g., silicon oxide or silicon nitride, or an organic insulating material, e.g., benzocyclobutene or photo-acryl.

The light emitting diode D is disposed on the planarization layer 134 and includes a first electrode 140, which is connected to the drain electrode 132 of the TFT Tr, a light emitting layer 142 on the first electrode 140 and a second electrode 144 on the light emitting layer 142. The light emitting diode D is disposed at each of the red, green and blue pixel regions and emits red light, green light and blue light in the red, green and blue pixel regions, respectively.

The first electrode 140 is separately formed in each pixel region P. The first electrode 140 may be an anode and may be formed of a conductive material having a relatively high work function. For example, the first electrode 140 may be formed of a conductive material having a relatively high work function, e.g., a transparent conductive oxide (TCO). For example, the first electrode 140 may include at least one of indium-tin-oxide (ITO), indium-zinc-oxide (IZO), indium-tin-zinc oxide (ITZO), tin oxide (SnO), zinc oxide (ZnO), indium-copper-oxide (ICO) and aluminum-zinc-oxide (Al:ZnO, AZO).

The first electrode 140 may have a single-layered structure including the transparent conductive oxide material layer. Alternatively, the first electrode 140 may further include a reflective layer to have a double-layered structure or a triple-layered structure. Namely, the first electrode 140 may be a reflective electrode.

For example, the reflective layer may include silver (Ag) or aluminum-palladium-copper alloy (APC). For example, the first electrode 140 may have a double-layered structure of Ag/ITO or APC/ITO or a triple-layered structure of ITO/Ag/ITO or ITO/APC/ITO.

A bank layer 146 is formed on the planarization layer 134 to cover an edge of the first electrode 140. Namely, the bank layer 146 is positioned at a boundary of the pixel region and exposes a center of the first electrode 140 in the pixel region P. The bank may surround the light emitting diode D.

The bank 146 may be a transparent bank or a light-absorbing bank (e.g., a light-shielding bank, a black bank or an opaque bank). For example, the light-absorbing bank (e.g., the light-shielding bank, the black bank or the opaque bank) may include a light-absorbing particle (or a black particle). The light-absorbing bank (e.g., the light-shielding bank, the black bank or the opaque bank) may further include an organic insulating material. The black particle may be one of carbon black, carbon nano tube (CNT) and graphene, and the organic insulating material may be one of photo-acryl, benzocyclobutene and polyimde.

In addition, a spacer 148 is formed on the bank layer 146. The bank layer 146 and the spacer 148 may be formed of the same material.

The light emitting layer 142 including an emitting material layer (EML) is formed on the first electrode 160. The light emitting layer 142 may have a single-layered structure including the EML.

The EML may include an organic emitting material or an inorganic emitting material. Namely, the light emitting display device 100 of the present disclosure may be an organic light emitting display device or an inorganic light emitting display device.

In the organic light emitting display device, the EML may include a host and a dopant (i.e., an emitter). In the red pixel region, the EML may include a red host and a red dopant. In the green pixel region, the EML may include a green host and a green dopant. In the blue pixel region, the EML may include a blue host and a blue dopant.

The light emitting layer 142 may further include at least one of a hole injection layer (HIL), a hole transport layer (HTL), an electron blocking layer (EBL), a hole blocking layer (HBL), an electron transport layer (ETL) and an electron injection layer (EIL) to have a multi-layered structure.

In an aspect of the present disclosure, the light emitting diode D may emi white light at each of the red, green and blue pixel regions. For example, the light emitting layer 142 of the light emitting diode D may include a first emitting part including a first EML, a second emitting part including a second EML and a charge generation layer (CGL) between the first and second emitting parts to have a double stack structure. In this case, one of the first and second EMLs may be a blue EML, and the other one of the first and second EMLs may be a yellow-green EML or include red and green EMLs.

In addition, the light emitting layer 142 of the light emitting diode D may further include a third emitting part including a third EML and a CGL between the second and third emitting parts to have a triple stack structure. In this case, the third EML may be a blue EML.

The second electrode 144 is formed over the substrate 101 where the organic emitting layer 142 is formed. The second electrode 144 covers an entire surface of the display area and may be formed of a conductive material having a relatively low work function to serve as a cathode. For example, the second electrode 144 may be formed of a material having high reflectance, such as aluminum (Al), magnesium (Mg), calcium (Ca), silver (Ag), their alloys or their combinations. The second electrode 144 may have a thin profile (small thickness) to provide a light transmittance property (or a semi-transmittance property).

An encapsulation layer (or encapsulation film) 150 is formed on the second electrode 144 to prevent penetration of moisture into the light emitting diode D. The encapsulation layer 150 includes a first inorganic insulating layer 152, an organic insulating layer 154 and a second inorganic insulating layer 156 sequentially stacked, but it is not limited thereto. The encapsulation layer 150 may be omitted.

Each of the first and second inorganic insulating layers 152 and 156 may be formed of an inorganic insulating material, e.g., silicon oxide or silicon nitride. The organic insulating layer 154 may be formed of an organic insulating material, e.g., epoxy resin or photo-acryl (or photosensitive acrylic polymer).

The organic insulating layer 154 is disposed between the first and second inorganic insulating layers 152 and 156. The organic insulating layer 154 can planarize a step difference to provide a flat top surface.

A touch electrode layer including a first touch electrode 166 and a second touch electrode 168 is disposed on the encapsulation layer 150. For example, a connection electrode 162 may be formed on the encapsulation layer 150, and a first insulating material layer 164a including first and second contact holes, which respectively expose both ends of the connection electrode 162, may be formed on the connection electrode 162. The first and second touch electrodes 166 and 168 may be formed on the first insulating material layers 164a. Adjacent first touch electrodes 166 may contact the connection electrode 162 through the first and second contact holes to be electrically connected to each other. The first insulating material layer 164a may be formed of an inorganic insulating material, e.g., silicon oxide or silicon nitride.

A buffer layer may be further formed between the second inorganic insulating layer 156 of the encapsulation layer 150 and the first insulating material layer 164a. The buffer layer may be formed of an inorganic insulating material, e.g., silicon oxide or silicon nitride.

A second insulating material layer 164b may be formed on the first and second touch electrodes 166 and 168. The second insulating material layer 164b may be formed of an inorganic insulating material, e.g., silicon oxide or silicon nitride, or an organic insulating material, e.g., benzocyclobutene or photo-acryl.

A black matrix 170 and a color filter layer 172 may be formed on the second insulating material layer 164b.

Alternatively, the connection electrode 162, the first insulating material layer 164a, the first touch electrode 166, the second touch electrode 168, the second insulating material layer 164b may be omitted so that the black matrix 170 and the color filter layer 172 may be formed on the encapsulation layer 150.

The black matrix 170 is formed at an edge of the pixel region P and includes an opening in correspondence to the light emitting diode D. For example, the black matrix 170 may include a black resin or carbon black.

The color filter layer 172 corresponds to the opening of the black matrix 170.

When the pixel region P includes the red, green and blue pixel regions, the color filter layer 172 may include a red color filter pattern corresponding to the red pixel region, a green color filter pattern corresponding to the green pixel region and a blue color filter pattern corresponding to the blue pixel region.

The red color filter pattern may include at least one of a red dye and a red pigment, the green color filter pattern may include at least one of a green dye and a green pigment, and the blue color filter pattern may include at least one of a blue dye and a blue pigment.

Although not shown, a protection layer may be formed on the second insulating material layer 164b, and the black matrix 170 and the color filter layer 172 may be formed on the protection layer. The protection layer may be formed of an inorganic insulating material, e.g., silicon oxide or silicon nitride.

A convex lens 182 is disposed on the color filter layer 172. A plurality of convex lenses 182 corresponds to one pixel region P. For example, a first insulating layer 180 may be formed on the color filter layer 172, and the convex lens 182 may be provided on a upper surface of the first insulating layer 180. The first insulating layer 180 with the convex lens 182 may be referred to as a lens layer. The first insulating layer 180 with the convex lens 182 may be formed of an organic insulating material, e.g., an epoxy resin or photo-acryl.

The convex lens 182 may be disposed on an entire display region. For example, a planar area of the convex lens 182 may be substantially same as that of the display region.

In an embodiment of the present disclosure, the convex lens may be only disposed on the color filter layer corresponding to the pixel region, For example, a planar area of the convex lens may be substantially same as that of the color filter layer. For example, the first insulating layer has an uneven top surface with the convex lens in correspondence to the color filter layer and an even (e.g. a flat) top surface without the convex lens in correspondence to the black matrix. In other words, the first insulating layers may have an uneven top surface in correspondence to the color filter layer and an even top surface outside the black matrix. For example, the first insulating layer may have an uneven top surface with the convex lens in correspondence to the color filter layer and an even top surface in a region between adjacent color filter layers.

In an embodiment of the present disclosure, an end of the color filter layer and an end of the convex lens may be disposed on an end of the black matrix.

The convex lens 182 has a uniform shape and size in an entire display region. For example, the convex lens 182 may have a honeycomb shape in a plan view, and each of the plurality of convex lens 182 may have the same vertical length (i.e., a depth) and a horizontal length (i.e., a width).

A second insulating layer 174 is formed on the convex lens 182. The second insulating layer 174 protects the convex lens 182 and provides a flat top surface. The second insulating layer 174 may be formed of an organic insulating material, e.g., an epoxy resin or photo-acryl.

When the convex lens is disposed only on the color filter layer, a height of the convex lens from the substrate may be greater than a height of the even top surface of the first insulating layer from the substrate. As a result, the second insulating layer may have a first thickness in correspondence to the convex lens and a second thickness, which is greater than the first thickenss, in correspondence to the even top surface.

In the light emitting display device 100 according to the first embodiment of the present disclosure, the light from the light emitting diode D passes through the color filter layer 172, the convex lens 182 and the second insulating layer 174 so that an image can be displayed at a surface of the second insulating layer 174.

The light emitting display device 100 may be a foldable display device. The light emitting display device 100 can be folded along a folding axis in a display region. For example, the substrate 101 can be folded so that the convex lens 182 in a first region of the display region face the convex lens 182 in a second region of the display region. Alternatively, the substrate 101 can be folded so that the convex lens 182 in a first region of the display region are disposed over the convex lens 182 in a second region of the display region with the substrate 101 therebetween.

The light emitting display device 100 includes a color filter layer 172 on or over the encapsulation layer 150 without a polarization plate so that an ambient light reflection can be reduced. Namely, in the light emitting display device 100, the brightness decrease by the polarization plate can be minimized or reduced, and the display quality decrease by an ambient light reflection can be prevented.

In addition, without the convex lens 182, an ambient light diffraction mura may be occurred by a step difference generated by the TFT Tr. The ambient light diffraction may be intensified by the color filter layer 172 so that a rainbow mura may be occurred by an interference between adjacent pixel regions P. However, the light emitting display device 100 of the present disclosure includes the convex lens 182 so that the ambient light diffraction mura and/or the rainbow mura may be minimized or prevented or reduced. Namely, the light may be dispersed or scattered by the convex lens 182 so that the ambient light diffraction mura and/or the rainbow mura may be minimized or prevented or reduced.

Accordingly, in the light emitting display device 100 according to the first embodiment of the present disclosure, without the brightness decrease and the rainbow mura, the ambient light reflection can be prevented, and high-quality image can be provided.

However, when the convex lens 182 having the same shape and size is formed on the color filter layer 172, a moiré problem may occur so that a display quality may be degraded.

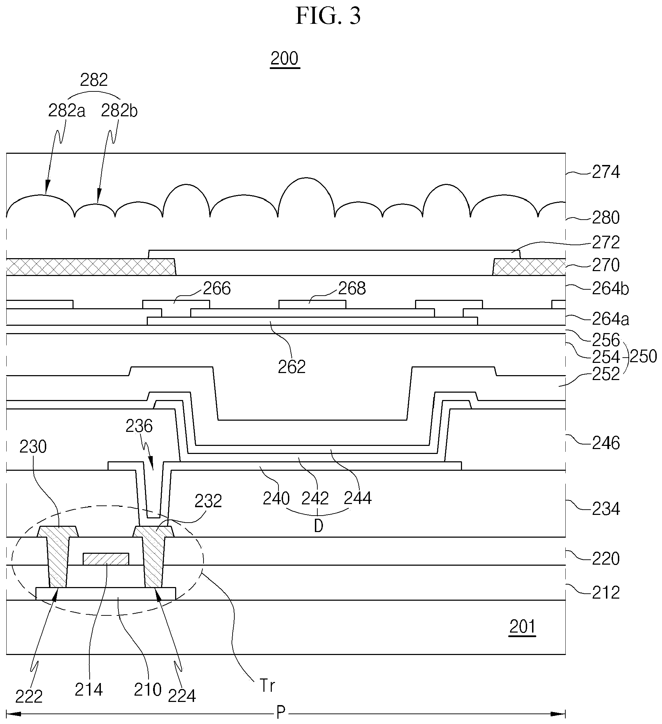

FIG. 3 is a schematic cross-sectional view illustrating a light emitting display device according to a second embodiment of the present disclosure.

As shown in FIG. 2, a light emitting display device 200 includes a substrate 201, a light emitting diode D over the substrate 201, a color filter layer 272 over the light emitting diode D and a plurality of convex lenses 282, which have a difference in a size and/or a shape, on the color filter layer 272.

A pixel region P including red, green and blue pixel regions is defined on the substrate 201. In addition, the pixel region P may further include a white pixel region.

A TFT Tr including a semiconductor layer 210, a gate electrode 214, a source electrode 230 and a drain electrode 232 is formed on the substrate 201.

In addition, a gate insulating layer 212 is disposed between the semiconductor layer 210 and the gate electrode 214, and the gate electrode 214 and each of the source and drain electrodes 230 and 232 are insulated by an interlayer insulating layer 220.

A planarization layer 234, which includes a drain electrode 236 exposing the drain electrode 232, is disposed on the TFT Tr, and the light emitting diode D including a first electrode 240, a light emitting layer 242 and a second electrode 244 is disposed on the planarization layer 234.

The light emitting diode D may emit red, green and blue light in the red, green and blue pixel regions, respectively. Alternatively, the light emitting diode D may emit white light in the red, green and blue pixel region.

A bank layer 246 corresponding to a boundary of the pixel region P is disposed on the planarization layer 234, and a spacer may be disposed on the bank 246.

An encapsulation layer 250 is formed on the second electrode 244 to prevent penetration of moisture into the light emitting diode D. The encapsulation layer 250 includes a first inorganic insulating layer 252, an organic insulating layer 254 and a second inorganic insulating layer 256 sequentially stacked.

A connection electrode 262 may be formed on the encapsulation layer 250, and a first insulating material layer 264a may be formed on the connection electrode 262. A first touch electrode 266 and a second touch electrode 268 may be formed on the first insulating material layer 264a, and a second insulating material layer 264b may be formed on the first and second touch electrodes 266 and 268.

A black matrix 270 and a color filter layer 272 may be formed on the second insulating material layer 264b. The black matrix 270 surrounds the pixel region P and includes an opening in correspondence to the pixel region P. The color filter layer 272 is formed the opening of the black matrix 270 to correspond to the pixel region P.

A convex lens 282 is disposed on the color filter layer 272. A plurality of convex lenses 282 corresponds to one pixel region P. For example, a first insulating layer 280 may be formed on the color filter layer 272, and the convex lens 282 may be provided on a upper surface of the first insulating layer 280. The first insulating layer 280 with the convex lens 282 may be referred to as a lens layer.

The convex lenses 282 have a difference in at least one of a size and a shape and includes a first convex lens 282a and a second convex lens 282b. Namely, the first and second convex lenses 282a and 282b have a difference in at least one of a size. In other words, a plurality of random convex lenses 282 are provided over the color filter layer 272.

A second insulating layer 274 is formed on the convex lens 282. The second insulating layer 274 protects the convex lens 282 and provides a flat top surface.

In the light emitting display device 200 according to the first embodiment of the present disclosure, the light from the light emitting diode D passes through the color filter layer 272, the convex lens 282 and the second insulating layer 274 so that an image can be displayed at a surface of the second insulating layer 274.

The light emitting display device 200 includes a color filter layer 272 on or over the encapsulation layer 250 without a polarization plate so that an ambient light reflection can be reduced. Namely, in the light emitting display device 200, the brightness decrease by the polarization plate can be minimized or reduced, and the display quality decrease by an ambient light reflection can be prevented.

In addition, without the convex lens 282, an ambient light diffraction mura may be occurred by a step difference generated by the TFT Tr. The ambient light diffraction may be intensified by the color filter layer 272 so that a rainbow mura may be occurred by an interference between adjacent pixel regions P. However, the light emitting display device 200 of the present disclosure includes the convex lens 282 so that the ambient light diffraction mura and/or the rainbow mura may be minimized or prevented or reduced. Namely, the light may be dispersed or scattered by the convex lens 282 so that the ambient light diffraction mura and/or the rainbow mura may be minimized or prevented or reduced.

Moreover, since the convex lenses 282 have a difference in a size and/or a shape, the moiré pattern, which may be occurred by the convex lens 182, which has the same size and shape, in the light emitting display device 100 according to the first embodiment of the present disclosure, can be prevented.

Accordingly, in the light emitting display device 200 according to the second embodiment of the present disclosure, without decreasing the brightness, the rainbow mura and moiré pattern, the ambient light reflection can be prevented, and high quality image can be provided.

However, it is difficult to control the process of forming convex lenses 282 having different sizes and/or shapes, and a problem of brightness non-uniformity occurs between convex lenses 282 having different shapes.

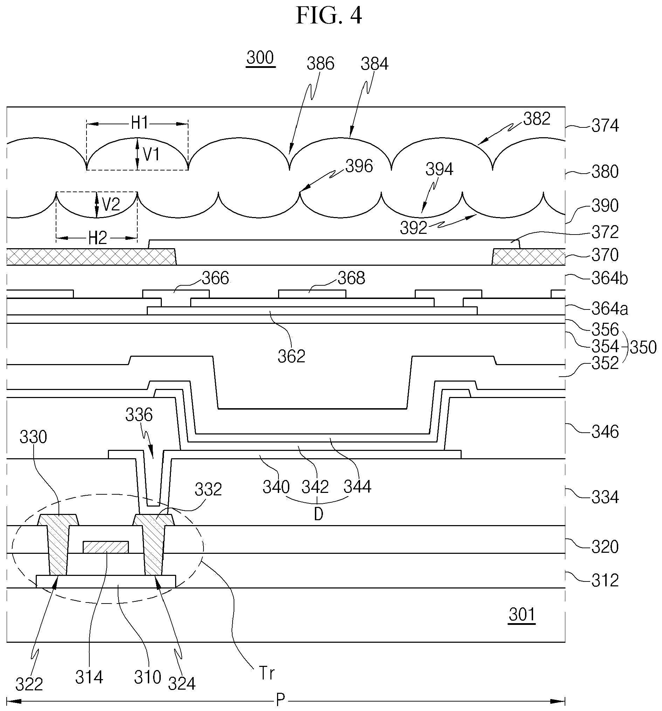

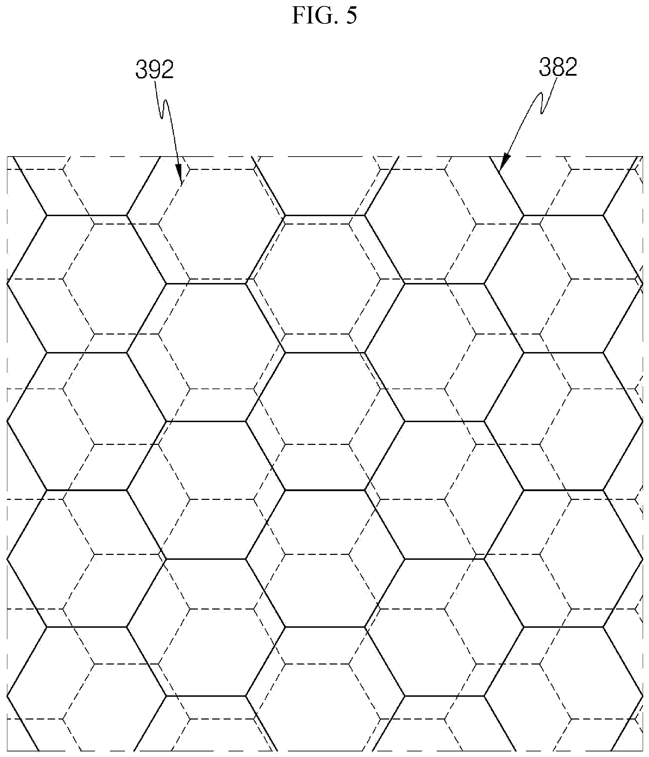

FIG. 4 is a schematic cross-sectional view illustrating a light emitting display device according to a third embodiment of the present disclosure, and FIG. 5 is a schematic plan view showing a convex lens and a concave lens of the light emitting display device according to the third embodiment of the present disclosure.

As shown in FIGs. 4 and 5, a light emitting display device 300 includes a substrate 301, a light emitting diode D over the substrate 301, a convex lens 382 over the light emitting diode D and a concave lens 392 between the light emitting diode D and the convex lens 382.

A pixel region P including red, green and blue pixel regions is defined on the substrate 301. In addition, the pixel region P may further include a white pixel region.

A TFT Tr including a semiconductor layer 310, a gate electrode 314, a source electrode 330 and a drain electrode 332 are formed on the substrate 301.

In addition, a gate insulating layer 312 is disposed between the semiconductor layer 310 and the gate electrode 314, and the gate electrode 314 and each of the source and drain electrodes 330 and 332 are insulated by an interlayer insulating layer 320.

A planarization layer 334, which includes a drain electrode 336 exposing the drain electrode 332, is disposed on the TFT Tr, and the light emitting diode D including a first electrode 340, a light emitting layer 342 and a second electrode 344 is disposed on the planarization layer 334.

The light emitting diode D may emit red, green and blue light in the red, green and blue pixel regions, respectively. Alternatively, the light emitting diode D may emit white light in the red, green and blue pixel region.

A bank layer 346 corresponding to a boundary of the pixel region P is disposed on the planarization layer 334.

An encapsulation layer 350 is formed on the second electrode 344 to prevent penetration of moisture into the light emitting diode D. The encapsulation layer 350 includes a first inorganic insulating layer 352, an organic insulating layer 354 and a second inorganic insulating layer 356 sequentially stacked.

A connection electrode 362 may be formed on the encapsulation layer 350, and a first insulating material layer 364a may be formed on the connection electrode 362. A first touch electrode 366 and a second touch electrode 368 may be formed on the first insulating material layer 364a, and a second insulating material layer 364b may be formed on the first and second touch electrodes 366 and 368.

A black matrix 370 and a color filter layer 372 may be formed on the second insulating material layer 364b. The black matrix 370 surrounds the pixel region P and includes an opening in correspondence to the pixel region P. The color filter layer 372 is formed within the opening of the black matrix 370 to correspond to the pixel region P.

The concave lens 392 is disposed over the color filter layer 372. A plurality of concave lenses 392 corresponds to one pixel region P. For example, a first insulating layer 390 may be formed on the color filter layer 372, and the concave lens 392 may be provided on a upper surface of the first insulating layer 390. The concave lens 392 covers at least a part of the black matrix 370. Namely, the concave lens 392 may overlap at least a part of the black matrix 370.

A convex lens 382 is disposed on the concave lens 392. A plurality of convex lenses 382 corresponds to one pixel region P. For example, a second insulating layer 380 may be formed on the concave lens 392, and the convex lens 382 may be provided on a upper surface of the second insulating layer 380.

A third insulating layer 374 is formed on the convex lens 382. The third insulating layer 374 protects the convex lens 382 and provides a flat top surface.

A refractive index of each of the first insulating layer 390 and the third insulating layer 374 may be greater than that of the second insulating layer 380. The refractive index of the first insulating layer 390 and the refractive index of the third insulating layer 374 may be the same or different.

In an aspect of the present disclosure, the refractive index of the first insulating layer 390 may be greater than the refractive index of the third insulating layer 374. A difference between the refractive index of the first insulating layer 390 and the refractive index of the second insulating layer 380 may be 0.1 or less.

In an aspect of the present disclosure, the refractive index of the third insulating layer 374 may be greater than the refractive index of the first insulating layer 390. A difference between the refractive index of the third insulating layer 374 and the refractive index of the second insulating layer 380 may be 0.1 or less.

In an aspect of the present disclosure, the refractive index of the first insulating layer 390 may be equal to the refractive index of the third insulating layer 374. A difference between each of the refractive index of the first insulating layer 390 and the refractive index of the third insulating layer 374 and the refractive index of the second insulating layer 380 may be 0.1 or less.

In an aspect of the present disclosure, each of the refractive index of the first insulating layer 390 and the refractive index of the third insulating layer 374 may have a range of 1.5 to 1.65, and the refractive index of the second insulating layer 380 may have a range of 1.45 to 1.55.

Each of the first to third insulating layers 390, 380 and 374 may be formed of an organic insulating material. For example, each of the first to third insulating layers 390, 380 and 374 may be formed of epoxy resin or photo-acryl.

The convex lens 382 and the concave lens 392 are alternately arranged. For example, each of the convex lens 382 and the concave lens 392 may have a honeycomb shape, but it is not limited thereto.

One end 386 of at least one of the plurality of convex lenses 382 is positioned between both ends 396 of the concave lens 392. In other words, a center 384 of at least one of the plurality of convex lenses 382 is positioned between two centers 394 of adjacent two concave lenses 392. Namely, at least one of the plurality of convex lenses 382 incompletely overlaps and partially overlaps the concave lens 392.

Each of the plurality of convex lenses 382 has a first vertical lens (i.e., first depth) V1 and a first horizontal length (i.e., first width) H1, and each of the plurality of concave lenses 392 has a second vertical lens (i.e., second depth) V2 and a second horizontal length (i.e., second width) H2.

An aspect ratio (i.e., V1/H1) of the convex lens 382 and an aspect ratio (i.e., V2/H2) of the concave lens 392 may be the same or different. The aspect ratio (i.e., V1/H1) of the convex lens 382 may have a range of 5% to 20%, and the aspect ratio (i.e., V2/H2) of the concave lens 392 may have a range of 5% to 20%. The plurality of convex lenses 382 may have the same aspect ratio in each pixel region P. For example, each of the plurality of convex lenses 382 may have the same first depth V1 and the same first width H1. The plurality of concave lenses 392 may have the same aspect ratio in each pixel region P. For example, each of the plurality of concave lenses 392 may have the same second depth V2 and the same second width H2.

The first width H1 of the convex lens 382 and the second width H2 of the concave lens 392 may be the same or different. In an aspect of the present disclosure, the first width H1 of the convex lens 382 may be greater than the second width H2 of the concave lens 392.

In the light emitting display device 300 according to the third embodiment of the present disclosure, the light from the light emitting diode D passes through the color filter layer 372, the first insulating layer 390, the concave lens 392, the second insulating layer 380, the convex lens 382 and the third insulating layer 374 so that an image can be displayed at a surface of the third insulating layer 374.

The light emitting display device 300 includes a color filter layer 372 on or over the encapsulation layer 350 without a polarization plate so that an ambient light reflection can be reduced. Namely, in the light emitting display device 300, the brightness decrease by the polarization plate can be minimized or reduced, and the display quality decrease by an ambient light reflection can be prevented.

In addition, without the convex lens 382 and concave lens 392, an ambient light diffraction mura may occur by a step difference generated by the TFT Tr. The ambient light diffraction may be intensified by the color filter layer 372 so that a rainbow mura may occur by an interference between adjacent pixel regions P. However, the light emitting display device 300 of the present disclosure includes the convex lens 382 and concave lens 392, which are alternately arranged over the color filter layer 372, so that the ambient light diffraction mura and/or the rainbow mura may be minimized or prevented or reduced. Namely, the light may be dispersed or scattered by the convex lens 382 and concave lens 392 so that the ambient light diffraction mura and/or the rainbow mura may be minimized or prevented or reduced.

Accordingly, in the light emitting display device 300 according to the third embodiment of the present disclosure, without the brightness decrease, the ambient light diffraction mura and the rainbow mura and moiré pattern, the ambient light reflection can be prevented, and high-quality image can be provided.

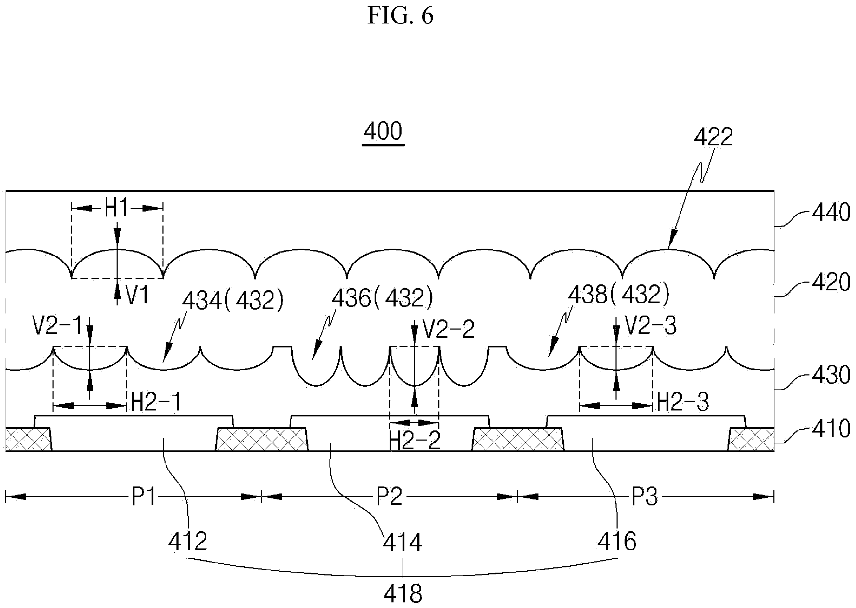

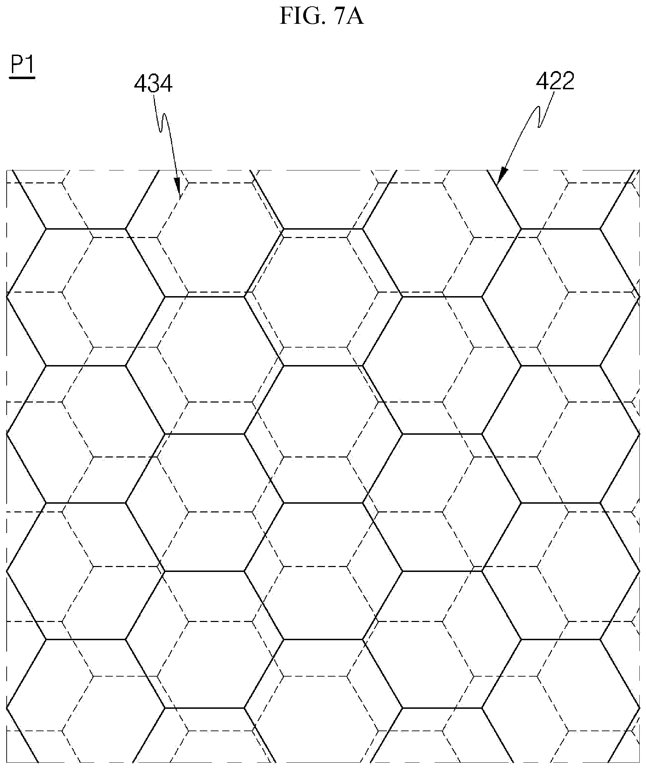

FIG. 6 is a schematic cross-sectional view illustrating a light emitting display device according to a fourth embodiment of the present disclosure, and FIGs. 7A to 7C are a schematic plan view showing a convex lens and a concave lens in first to third pixel regions of the light emitting display device according to the fourth embodiment of the present disclosure, respectively.

As shown in FIG. 6, a light emitting display device 400 includes a substrate 301 (of FIG. 4) including a first pixel region P1, a second pixel region P2 and a third pixel region P3, a light emitting diode D (of Fig. 4) over the substrate 301, a convex lens 422 over the light emitting diode D and a concave lens 432 between the light emitting diode D and the convex lens 422.

The first pixel region P1 may be one of red, green and blue pixel regions, the second pixel region P2 may be another one of the red, green and blue pixel regions, and the third pixel region P3 may be the other one of the red, green and blue pixel regions. The substrate 301 may further include a fourth pixel region being a white pixel region.

In an aspect of the present disclosure, the first pixel region P1 may be the red pixel region, the second pixel region P2 may be the green pixel region, and the third pixel region P3 may be the blue pixel region.

For convenience of explanation, the configuration under the black matrix 410 and the color filter layer 418 are omitted.

For example, referring to FIG. 4, the TFT Tr including the semiconductor layer 310, the gate electrode 314, the source electrode 330 and the drain electrode 332 is formed on the substrate 301, and the light emitting diode D, which is electrically connected to the TFT Tr, is disposed over the TFT Tr.

In an aspect of the present disclosure, the light emitting diode D may emit the red light at the first pixel region P1, the green light at the second pixel region P2 and the blue light at the third pixel region P3.

Alternatively, the light emitting diode D may emit the white light at the first to third pixel regions P1, P2 and P3.

The encapsulating layer 350 is disposed over the light emitting diode D, and the touch electrode layer including the first and second touch electrodes 366 and 368 are disposed over the encapsulating layer 350.

Referring again to FIG. 6, a black matrix 410 and a color filter layer 418 may be formed on the encapsulating layer 350 or the touch electrode layer. The black matrix 410 may surround each of the first to third pixel regions P1, P2 and P3 and include an opening in correspondence to each of the first to third pixel regions P1, P2 and P3. The color filter layer 418 is formed within the opening of the black matrix 410 to correspond to each of the first to third pixel regions P1, P2 and P3.

The color filter layer includes a first color filter pattern 412 corresponding to the first pixel region P1, a second color filter pattern 414 corresponding to the second pixel region P2 and a third color filter pattern 416 corresponding to the third pixel region P3. The first color filter pattern 412 is one of a red color filter pattern, a green color filter pattern and a blue color filter pattern, the second color filter pattern 414 is the other of the red color filter pattern, the green color filter patter, and the blue color filter pattern, and the third color filter pattern 416 is the remaining one of the red color filter pattern, the green color filter pattern and the blue color filter pattern. In an aspect of the present disclosure, the first color filter pattern 412 may be a red color filter pattern, the second color filter pattern 414 may be a green color filter pattern, and the third color filter pattern 416 may be a blue color filter pattern. That is, the first color filter pattern 412, the second color filter pattern 414 and the third color filter pattern 416 may be different from each other.

The concave lens 432 is disposed over the color filter layer 418. A plurality of concave lenses 432 are formed to correspond to the first to third pixel regions P1, P2 and P3. For example, a first insulating layer 430 may be formed on the color filter layer 418, and the concave lens 432 may be provided on a upper surface of the first insulating layer 430.

A convex lens 422 is disposed on the concave lens 432. A plurality of convex lenses 422 are formed to correspond to the first to third pixel regions P1, P2 and P3. For example, a second insulating layer 420 may be formed on the concave lens 432, and the convex lens 422 may be provided on a upper surface of the second insulating layer 420.

A third insulating layer 440 is formed on the convex lens 422. The third insulating layer 440 protects the convex lens 422 and provides a flat top surface.

A refractive index of each of the first insulating layer 430 and the third insulating layer 440 may be greater than that of the second insulating layer 420. The refractive index of the first insulating layer 430 and the refractive index of the third insulating layer 440 may be the same or different.

In an aspect of the present disclosure, the refractive index of the first insulating layer 430 may be greater than the refractive index of the third insulating layer 440. A difference between the refractive index of the first insulating layer 430 and the refractive index of the second insulating layer 420 may be 0.1 or less.

In an aspect of the present disclosure, the refractive index of the third insulating layer 440 may be greater than the refractive index of the first insulating layer 430. A difference between the refractive index of the third insulating layer 440 and the refractive index of the second insulating layer 420 may be 0.1 or less.

In an aspect of the present disclosure, the refractive index of the first insulating layer 430 may be equal to the refractive index of the third insulating layer 440. A difference between each of the refractive index of the first insulating layer 430 and the refractive index of the third insulating layer 440 and the refractive index of the second insulating layer 420 may be 0.1 or less.

In an aspect of the present disclosure, each of the refractive index of the first insulating layer 430 and the refractive index of the third insulating layer 440 may have a range of 1.5 to 1.65, and the refractive index of the second insulating layer 420 may have a range of 1.45 to 1.55.

Each of the first to third insulating layers 430, 420 and 440 may be formed of an organic insulating material. For example, each of the first to third insulating layers 430, 420 and 440 may be formed of epoxy resin or photo-acryl.

Referring to FIGs. 7A to 7C with FIG. 6, the convex lens 422 and the concave lens 432 are alternately arranged. For example, each of the convex lens 422 and the concave lens 432 may have a honeycomb shape, but it is not limited thereto.

One end of at least one of the plurality of convex lenses 422 is positioned between both ends of the concave lens 432. In other words, a center of at least one of the plurality of convex lenses 422 is positioned between two centers of adjacent two concave lenses 432. Namely, at least one of the plurality of convex lenses 422 incompletely overlaps and partially overlaps the concave lens 432.

Each of the plurality of convex lenses 422 has a first vertical lens (i.e., first depth) V1 and a first horizontal length (i.e., first width) H1. An aspect ratio (i.e., V1/H1) of the convex lens 422 may have a range of 5% to 20%. The plurality of convex lenses 422 may have the same shape and size in the first to third pixel regions P1, P2 and P3.

The plurality of concave lenses 432 include a first concave lens 434 corresponding to the first pixel region P2, a second concave lens 436 corresponding to the second pixel region P2 and a third concave lens 438 corresponding to the third pixel region P3.

The first concave lens 434 has a depth V2-1 and a width H2-1. The second concave lens 436 has a depth V2-2 and a width H2-2. The third concave lens 438 has a depth V2-3 and a width H2-3.

The first concave lens 434 in the first pixel region P1 has a first aspect ratio (i.e., V2-1/H2-1). The second concave lens 436 in the second pixel region P2 has a second aspect ratio (i.e., V2-2/H2-2). The third concave lens 438 in the third pixel region P3 has a third aspect ratio (i.e., V2-3/H2-3).

The second aspect ratio (i.e., V2-2/H2-2) of the second concave lens 436 is greater than each of the third aspect ratio (i.e., V2-3/H2-3) of the third concave lens 438 and the first aspect ratio (i.e., V2-1/H2-1) of the first concave lens 434.

In an aspect of the present disclosure, the depth (V2-2) of the second concave lens 436 may be greater than the depth (V2-1) of the first concave lens 434 and the depth (V2-3) of the third concave lens 438.

In an aspect of the present disclosure, the width (H2-2) of the second concave lens 436 may be smaller than the width (H2-1) of the first concave lens 434 and the width (H2-3) of the third concave lens 438.

In an aspect of the present disclosure, the depth (V2-2) of the second concave lens 436 may be greater than the depth (V2-1) of the first concave lens 434 and the depth (V2-3) of the third concave lens 438, and the width (H2-2) of the second concave lens 436 may be smaller than the width (H2-1) of the first concave lens 434 and the width (H2-3) of the third concave lens 438.

The first, second and third pixel regions P1, P2, P3 may be the red, green and blue pixel regions, respectively.

Since the reflectance in the green pixel region is greater than that of the red and blue pixel regions, the second aspect ratio (i.e., V2-2/H2-2) of the second concave lens 436 is greater than each of the third aspect ratio (i.e., V2-3/H2-3) of the third concave lens 438 and the first aspect ratio (i.e., V2-1/H2-1) of the first concave lens 434 so that the reflectance difference in the first to third pixel regions P1, P2 and P3 can be compensated.

The first aspect ratio (i.e., V2-1/H2-1) of the first concave lens 434 and the third aspect ratio (i.e., V2-3/H2-3) of the third concave lens 438 may be the same or different. In an aspect of the present disclosure, the first aspect ratio (i.e., V2-1/H2-1) of the first concave lens 434 may be equal to or greater than the third aspect ratio (i.e., V2-3/H2-3) of the third concave lens 438.

In the light emitting display device 400 according to the fourth embodiment of the present disclosure, the light from the light emitting diode D passes through the color filter layer 418, the first insulating layer 430, the concave lens 432, the second insulating layer 420, the convex lens 422 and the third insulating layer 440 so that an image can be displayed at a surface of the third insulating layer 440.

The light emitting display device 400 includes a color filter layer 418 on or over the encapsulation layer 350 without a polarization plate so that an ambient light reflection can be reduced. Namely, in the light emitting display device 400, the brightness decrease by the polarization plate can be minimized or reduced, and the display quality decrease by an ambient light reflection can be prevented.

In addition, without the convex lens 422 and concave lens 432, an ambient light diffraction mura may occur by a step difference generated by the TFT Tr. The ambient light diffraction may be intensified by the color filter layer 418 so that a rainbow mura may occur by an interference between adjacent pixel regions P. However, the light emitting display device 400 of the present disclosure includes the convex lens 422 and concave lens 432, which are alternately arranged over the color filter layer 418, so that the ambient light diffraction mura and/or the rainbow mura may be minimized or prevented or reduced. Namely, the light may be dispersed or scattered by the convex lens 422 and concave lens 432 so that the ambient light diffraction mura and/or the rainbow mura may be minimized or prevented or reduced.

Moreover, since the concave lens 432 in the second pixel region P2, which has a relatively high reflectance, is relatively large, the reflectance difference between pixel regions P can be compensated.

Accordingly, in the light emitting display device 400 according to the third embodiment of the present disclosure, without the brightness decrease, the ambient light diffraction mura and the rainbow mura and moiré pattern, the ambient light reflection can be prevented, and high-quality image can be provided.

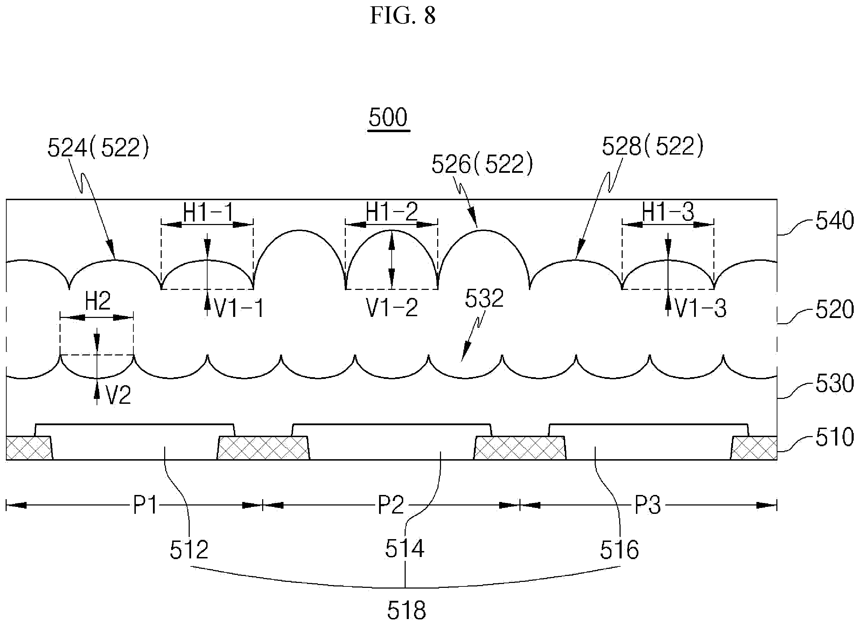

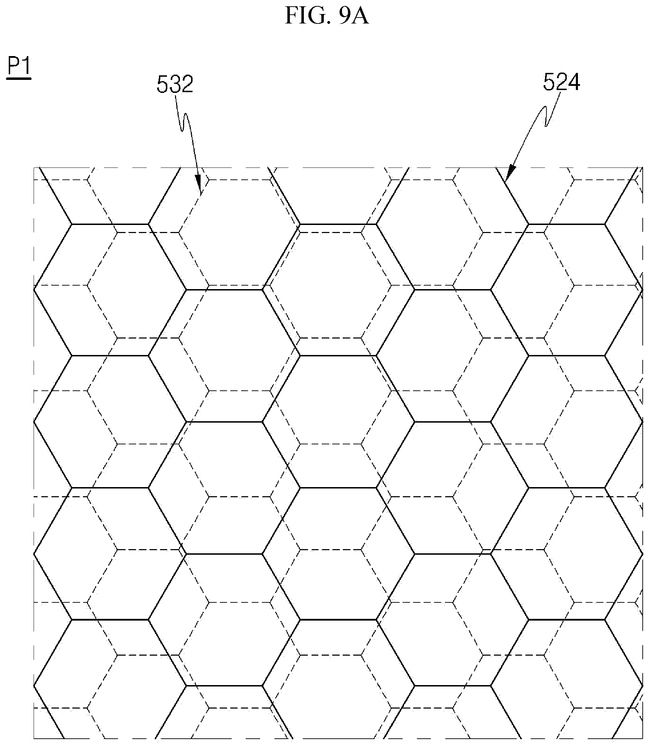

FIG. 8 is a schematic cross-sectional view illustrating a light emitting display device according to a fifth embodiment of the present disclosure, and FIGs. 9A to 9C are a schematic plan view showing a convex lens and a concave lens in first to third pixel regions of the light emitting display device according to the fifth embodiment of the present disclosure, respectively.

As shown in FIG. 8, a light emitting display device 500 includes a substrate 301 (of FIG. 4) including a first pixel region P1, a second pixel region P2 and a third pixel region P3, a light emitting diode D (of FIG. 4) over the substrate 301, a convex lens 522 over the light emitting diode D and a concave lens 532 between the light emitting diode D and the convex lens 522.

The first pixel region P1 may be one of red, green and blue pixel regions, the second pixel region P2 may be another one of the red, green and blue pixel regions, and the third pixel region P3 may be the other one of the red, green and blue pixel regions. The substrate 301 may further include a fourth pixel region being a white pixel region.

In an aspect of the present disclosure, the first pixel region P1 may be the red pixel region, the second pixel region P2 may be the green pixel region, and the third pixel region P3 may be the blue pixel region.

For convenience of explanation, the configuration under the black matrix 510 and the color filter layer 518 are omitted.

For example, referring to FIG. 4, the TFT Tr including the semiconductor layer 310, the gate electrode 314, the source electrode 330 and the drain electrode 332 is formed on the substrate 301, and the light emitting diode D, which is electrically connected to the TFT Tr, is disposed over the TFT Tr.

In an aspect of the present disclosure, the light emitting diode D may emit the red light at the first pixel region P1, the green light at the second pixel region P2 and the blue light at the third pixel region P3.

Alternatively, the light emitting diode D may emit the white light at the first to third pixel regions P1, P2 and P3.

The encapsulating layer 350 is disposed over the light emitting diode D, and the touch electrode layer including the first and second touch electrodes 366 and 368 are disposed over the encapsulating layer 350.

Referring again to FIG. 8, a black matrix 510 and a color filter layer 518 may be formed on the encapsulating layer 350 or the touch electrode layer. The black matrix 510 may surround each of the first to third pixel regions P1, P2 and P3 and include an opening in correspondence to each of the first to third pixel regions P1, P2 and P3. The color filter layer 518 is formed the opening of the black matrix 510 to correspond to each of the first to third pixel regions P1, P2 and P3.

The color filter layer includes a first color filter pattern 512 corresponding to the first pixel region P1, a second color filter pattern 514 corresponding to the second pixel region P2 and a third color filter pattern 516 corresponding to the third pixel region P3. The first color filter pattern 512 is one of a red color filter pattern, a green color filter pattern and a blue color filter pattern, the second color filter pattern 514 is the other of the red color filter pattern, the green color filter patter, and the blue color filter pattern, and the third color filter pattern 516 is the remaining one of the red color filter pattern, the green color filter pattern and the blue color filter pattern. In an aspect of the present disclosure, the first color filter pattern 512 may be a red color filter pattern, the second color filter pattern 514 may be a green color filter pattern, and the third color filter pattern 516 may be a blue color filter pattern. That is, the first color filter pattern 512, the second color filter pattern 514 and the third color filter pattern 516 may be different from each other.

The concave lens 532 is disposed over the color filter layer 518. A plurality of concave lenses 532 are formed to correspond to the first to third pixel regions P1, P2 and P3. For example, a first insulating layer 530 may be formed on the color filter layer 518, and the concave lens 532 may be provided on a upper surface of the first insulating layer 530.

A convex lens 522 is disposed on the concave lens 532. A plurality of convex lenses 522 are formed to correspond to the first to third pixel regions P1, P2 and P3. For example, a second insulating layer 520 may be formed on the concave lens 532, and the convex lens 522 may be provided on a upper surface of the second insulating layer 520.

A third insulating layer 540 is formed on the convex lens 522. The third insulating layer 540 protects the convex lens 522 and provides a flat top surface.

A refractive index of each of the first insulating layer 530 and the third insulating layer 540 may be greater than that of the second insulating layer 520. The refractive index of the first insulating layer 530 and the refractive index of the third insulating layer 540 may be the same or different.

In an aspect of the present disclosure, the refractive index of the first insulating layer 530 may be greater than the refractive index of the third insulating layer 540. A difference between the refractive index of the first insulating layer 530 and the refractive index of the second insulating layer 520 may be 0.1 or less.

In an aspect of the present disclosure, the refractive index of the third insulating layer 540 may be greater than the refractive index of the first insulating layer 530. A difference between the refractive index of the third insulating layer 540 and the refractive index of the second insulating layer 520 may be 0.1 or less.

In an aspect of the present disclosure, the refractive index of the first insulating layer 530 may be equal to the refractive index of the third insulating layer 540. A difference between each of the refractive index of the first insulating layer 530 and the refractive index of the third insulating layer 540 and the refractive index of the second insulating layer 520 may be 0.1 or less.

In an aspect of the present disclosure, each of the refractive index of the first insulating layer 530 and the refractive index of the third insulating layer 540 may have a range of 1.5 to 1.65, and the refractive index of the second insulating layer 520 may have a range of 1.45 to 1.55.

Each of the first to third insulating layers 530, 520 and 540 may be formed of an organic insulating material. For example, each of the first to third insulating layers 530, 520 and 540 may be formed of epoxy resin or photo-acryl.

Referring to FIGs. 9A to 9C with FIG. 8, the convex lens 522 and the concave lens 532 are alternately arranged. For example, each of the convex lens 522 and the concave lens 532 may have a honeycomb shape, but it is not limited thereto.

One end of at least one of the plurality of convex lenses 522 is positioned between both ends of the concave lens 532. In other words, a center of at least one of the plurality of convex lenses 522 is positioned between two centers of adjacent two concave lenses 532. Namely, at least one of the plurality of convex lenses 522 incompletely overlaps and partially overlaps the concave lens 532.

Each of the plurality of concave lenses 532 has a second vertical length (i.e., second depth) V2 and a second horizontal length (i.e., second width) H2. An aspect ratio (i.e., V2/H2) of the concave lenses 532 may have a range of 5% to 20%. The plurality of concave lenses 532 may have the same shape and size in the first to third pixel regions P1, P2 and P3.

The plurality of convex lenses 522 include a first convex lenses 524 corresponding to the first pixel region P2, a second convex lenses 526 corresponding to the second pixel region P2 and a third convex lenses 528 corresponding to the third pixel region P3.

Each of the first convex lenses 524 in the first pixel region P1 has a vertical length (i.e., depth) V1-1 and a horizontal length (i.e., width) H1-1. Each of the second convex lenses 526 in the second pixel region P2 has a vertical length V1-2 and a horizontal length H1-2. Each of the third convex lenses 528 in the third pixel region P3 has a vertical length V1-3 and a horizontal length H1-3.

Each of the first convex lenses 524 in the first pixel region P1 has a first aspect ratio (i.e., V1-1/H1-1). Each of the second convex lenses 526 in the second pixel region P2 has a second aspect ratio (i.e., V1-2/H1-2). Each of the third convex lenses 528 in the third pixel region P3 has a third aspect ratio (i.e., V1-3/H1-3).

The second aspect ratio (i.e., V1-1/H1-1) of the second convex lenses 526 is greater than each of the third aspect ratio (i.e., V1-3/H1-3) of the third convex lenses 528 and the first aspect ratio (i.e., V1-1/H1-1) of the first convex lenses 524.

In an aspect of the present disclosure, the depth (V1-2) of the second convex lenses 526 may be greater than the depth (V1-1) of the first convex lenses 524 and the depth (V1-3) of the third convex lenses 528.

In an aspect of the present disclosure, the width (H1-2) of the second convex lenses 526 may be smaller than the width (H1-1) of the first convex lenses 524 and the width (H1-3) of the third convex lenses 528.

In an aspect of the present disclosure, the depth (V1-2) of the second convex lenses 526 may be greater than the depth (V1-1) of the first convex lenses 524 and the depth (V1-3) of the third convex lenses 528, and the width (H1-2) of the second convex lenses 526 may be smaller than the width (H1-1) of the first convex lenses 524 and the width (H1-3) of the third convex lenses 528.

The first, second and third pixel regions P1, P2, P3 may be the red, green and blue pixel regions, respectively.

Since the reflectance in the green pixel region is greater than that of the red and blue pixel regions, the second aspect ratio (i.e., V1-2/H1-2) of the second convex lenses 526 is greater than each of the third aspect ratio (i.e., V1-3/H1-3) of the third convex lenses 528 and the first aspect ratio (i.e., V1-1/H1-1) of the first convex lenses 524 so that the reflectance difference in the first to third pixel regions P1, P2 and P3 can be compensated.

The first aspect ratio (i.e., V1-1/H1-1) of the first convex lenses 524 and the third aspect ratio (i.e., V1-3/H1-3) of the third convex lenses 528 may be the same or different. In an aspect of the present disclosure, the first aspect ratio (i.e., V1-1/H1-1) of the first convex lenses 524 may be equal to or greater than the third aspect ratio (i.e., V1-3/H1-3) of the third convex lenses 528.

In the light emitting display device 500 according to the fifth embodiment of the present disclosure, the light from the light emitting diode D passes through the color filter layer 518, the first insulating layer 530, the concave lens 532, the second insulating layer 520, the convex lens 522 and the third insulating layer 540 so that an image can be displayed at a surface of the third insulating layer 540.

The light emitting display device 500 includes a color filter layer 518 on or over the encapsulation layer 350 without a polarization plate so that an ambient light reflection can be reduced. Namely, in the light emitting display device 500, the brightness decrease by the polarization plate can be minimized or reduced, and the display quality decrease by an ambient light reflection can be prevented.

In addition, without the convex lens 522 and concave lens 532, an ambient light diffraction mura may be occurred by a step difference generated by the TFT Tr. The ambient light diffraction may be intensified by the color filter layer 518 so that a rainbow mura may be occurred by an interference between adjacent pixel regions P. However, the light emitting display device 500 of the present disclosure includes the convex lens 522 and concave lens 532, which are alternately arranged over the color filter layer 518, so that the ambient light diffraction mura and/or the rainbow mura may be minimized or prevented or reduced. Namely, the light may be dispersed or scattered by the convex lens 522 and concave lens 532 so that the ambient light diffraction mura and/or the rainbow mura may be minimized or prevented or reduced.

Moreover, since the convex lenses 522 in the second pixel region P2, which has a relatively high reflectance, is relatively large, the reflectance difference between pixel regions P can be compensated.

Accordingly, in the light emitting display device 500 according to the fifth embodiment of the present disclosure, without the brightness decrease, the ambient light diffraction mura and the rainbow mura and moiré pattern, the ambient light reflection can be prevented, and high-quality image can be provided.

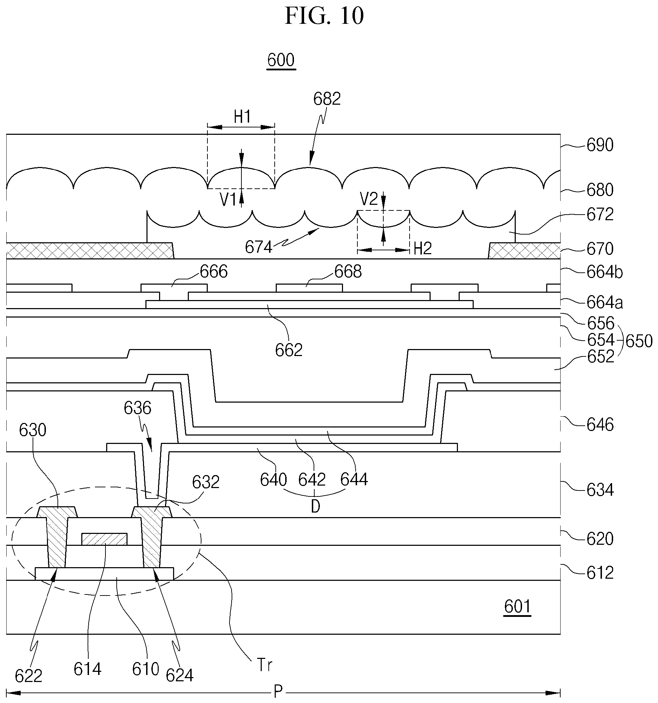

FIG. 10 is a schematic cross-sectional view illustrating a light emitting display device according to a sixth embodiment of the present disclosure.

As shown in FIG. 10, a light emitting display device 600 includes a substrate 601, a light emitting diode D over the substrate 601, a convex lens 682 over the light emitting diode D and a concave lens 674 between the light emitting diode D and the convex lens 682.

A pixel region P including red, green and blue pixel regions is defined on the substrate 601. In addition, the pixel region P may further include a white pixel region.

A TFT Tr including a semiconductor layer 610, a gate electrode 614, a source electrode 630 and a drain electrode 632 is formed on the substrate 601.

In addition, a gate insulating layer 612 is disposed between the semiconductor layer 610 and the gate electrode 614, and the gate electrode 614 and each of the source and drain electrodes 630 and 632 are insulated by an interlayer insulating layer 620.

A planarization layer 634, which includes a drain electrode 636 exposing the drain electrode 632, is disposed on the TFT Tr, and the light emitting diode D including a first electrode 640, a light emitting layer 642 and a second electrode 644 is disposed on the planarization layer 634.

The light emitting diode D may emit red, green and blue light in the red, green and blue pixel regions, respectively. Alternatively, the light emitting diode D may emit white light in the red, green and blue pixel region.

A bank layer 646 corresponding to a boundary of the pixel region P is disposed on the planarization layer 634.

An encapsulation layer 650 is formed on the second electrode 644 to prevent penetration of moisture into the light emitting diode D. The encapsulation layer 650 includes a first inorganic insulating layer 652, an organic insulating layer 654 and a second inorganic insulating layer 656 sequentially stacked.

A connection electrode 662 may be formed on the encapsulation layer 650, and a first insulating material layer 664a may be formed on the connection electrode 662. A first touch electrode 666 and a second touch electrode 668 may be formed on the first insulating material layer 664a, and a second insulating material layer 664b may be formed on the first and second touch electrodes 666 and 668.

A black matrix 670 and a color filter layer 672 may be formed on the second insulating material layer 664b. The black matrix 670 surrounds the pixel region P and includes an opening in correspondence to the pixel region P. The color filter layer 672 is formed the opening of the black matrix 670 to correspond to the pixel region P.

The concave lens 674 is disposed over the color filter layer 672. A plurality of concave lenses 674 corresponds to one pixel region P. A portion of the color filter layer 672 may be etched to provide the plurality of concave lenses 674 on a upper surface of the color filter layer 672. The color filter layer 672 may covers at least a part of the black matrix 670, and the concave lens 674 may be provided on the upper surface of the color filter layer 672. Accordingly, the concave lens 674 may cover at least a part of the black matrix 670. Namely, the concave lens 674 may overlap at least a part of the black matrix 670.

A convex lens 682 is disposed on the concave lens 674. A plurality of convex lenses 682 corresponds to one pixel region P. For example, a first insulating layer 680 may be formed on the concave lens 674, and the convex lens 682 may be provided on a upper surface of the first insulating layer 680.

A second insulating layer 690 is formed on the convex lens 682. The second insulating layer 690 protects the convex lens 682 and provides a flat top surface.

A refractive index of each of the color filter layer 672 and the second insulating layer 690 may be greater than that of the first insulating layer 680. The refractive index of the color filter layer 672 and the refractive index of the second insulating layer 690 may be the same or different.

In an aspect of the present disclosure, the refractive index of the color filter layer 672 may be greater than the refractive index of the second insulating layer 690. A difference between the refractive index of the color filter layer 672 and the refractive index of the first insulating layer 680 may be 0.1 or less.

In an aspect of the present disclosure, the refractive index of the second insulating layer 690 may be greater than the refractive index of the color filter layer 672. A difference between the refractive index of the second insulating layer 690 and the refractive index of the first insulating layer 680 may be 0.1 or less.

In an aspect of the present disclosure, the refractive index of the color filter layer 672 may be equal to the refractive index of the second insulating layer 690. A difference between each of the refractive index of the color filter layer 672 and the refractive index of the third second insulating layer 690 and the refractive index of the first insulating layer 680 may be 0.1 or less.

In an aspect of the present disclosure, each of the refractive index of the color filter layer 672 and the refractive index of the second insulating layer 690 may have a range of 1.5 to 1.65, and the refractive index of the first insulating layer 680 may have a range of 1.45 to 1.55.

Each of the color filter layer 672, the first and second insulating layers 680 and 690 may be formed of an organic insulating material. For example, each of the color filter layer 672, the first and second insulating layers 680 and 690 may be formed of epoxy resin or photo-acryl.

The convex lens 682 and the concave lens 674 are alternately arranged. For example, each of the convex lens 682 and the concave lens 674 may have a honeycomb shape, but it is not limited thereto.

One end of at least one of the plurality of convex lenses 682 is positioned between both ends of the concave lens 674. In other words, a center of at least one of the plurality of convex lenses 682 is positioned between two centers of adjacent two concave lenses 674. Namely, at least one of the plurality of convex lenses 682 incompletely overlaps and partially overlaps the concave lens 674.

Each of the plurality of convex lenses 682 has a first vertical lens (i.e., first depth) V1 and a first horizontal length (i.e., first width) H1, and each of the plurality of concave lenses 674 has a second vertical lens (i.e., second depth) V2 and a second horizontal length (i.e., second width) H2.

An aspect ratio (i.e., V1/H1) of the convex lens 682 and an aspect ratio (i.e., V2/H2) of the concave lens 674 may be the same or different. The aspect ratio (i.e., V1/H1) of the convex lens 682 may have a range of 5% to 20%, and the aspect ratio (i.e., V2/H2) of the concave lens 674 may have a range of 5% to 20%. The plurality of convex lenses 682 may have the same aspect ratio in each pixel region P. For example, each of the plurality of convex lenses 682 may have the same first depth V1 and the same first width H1. The plurality of concave lenses 674 may have the same aspect ratio in each pixel region P. For example, each of the plurality of concave lenses 674 may have the same second depth V2 and the same second width H2.

The first width H1 of the convex lens 682 and the second width H2 of the concave lens 674 may be the same or different. In an aspect of the present disclosure, the first width H1 of the convex lens 682 may be greater than the second width H2 of the concave lens 674.

The convex lens 682 is provided on an entire display region including the pixel regions P and a space between adjacent pixel regions P, while the concave lens 674 is provided only on an emission area of the pixel region P. Namely, the concave lens 674 is provided to correspond to the light emitting diode D. In other words, an area, in which the convex lens 682 is provided, may be larger than an area, in which the concave lens 674 is provided.

The pixel region P includes an emission area and a non-emission area surrounding the emission area. The emission area corresponds to the light emitting diode D or the color filter layer 672, and the non-emission area corresponds to the bank 646 or the black matrix 670. The convex lens 682 has an area corresponding to the emission area and the non-emission area, and the concave lens 674 has an area corresponding to the emission area.

The first insulating layer 680 in a portion of the pixel region P, e.g., an area corresponding to the light emitting diode D, may contact the color filter layer 672. The first insulating layer 680 in the rest portion of the pixel region P may contact the black matrix 670.

In the light emitting display device 600 according to the sixth embodiment of the present disclosure, the light from the light emitting diode D passes through the color filter layer 672, the concave lens 674, the first insulating layer 680, the convex lens 682 and the second insulating layer 690 so that an image can be displayed at a surface of the second insulating layer 690.

The light emitting display device 600 includes a color filter layer 672 on or over the encapsulation layer 650 without a polarization plate so that an ambient light reflection can be reduced. Namely, in the light emitting display device 600, the brightness decrease by the polarization plate can be minimized or reduced, and the display quality decrease by an ambient light reflection can be prevented.

In addition, without the convex lens 682 and concave lens 674, an ambient light diffraction mura may occur by a step difference generated by the TFT Tr. The ambient light diffraction may be intensified by the color filter layer 672 so that a rainbow mura may occur by an interference between adjacent pixel regions P. However, the light emitting display device 600 of the present disclosure includes the convex lens 682 and concave lens 674, which are alternately arranged over the color filter layer 672, so that the ambient light diffraction mura and/or the rainbow mura may be minimized or prevented or reduced. Namely, the light may be dispersed or scattered by the convex lens 682 and concave lens 674 so that the ambient light diffraction mura and/or the rainbow mura may be minimized or prevented or reduced.

Moreover, since the concave lens 674 is provided on the upper surface of the color filter layer 672 without an additional insulating layer, e.g., the first insulating layer 430 (of FIG. 4), the light emitting display device 600 may have a simple structure and low production cost.

Accordingly, in the light emitting display device 600 according to the sixth embodiment of the present disclosure, without the brightness decrease, the ambient light diffraction mura and the rainbow mura and moiré pattern, the ambient light reflection can be prevented, and high-quality image can be provided.

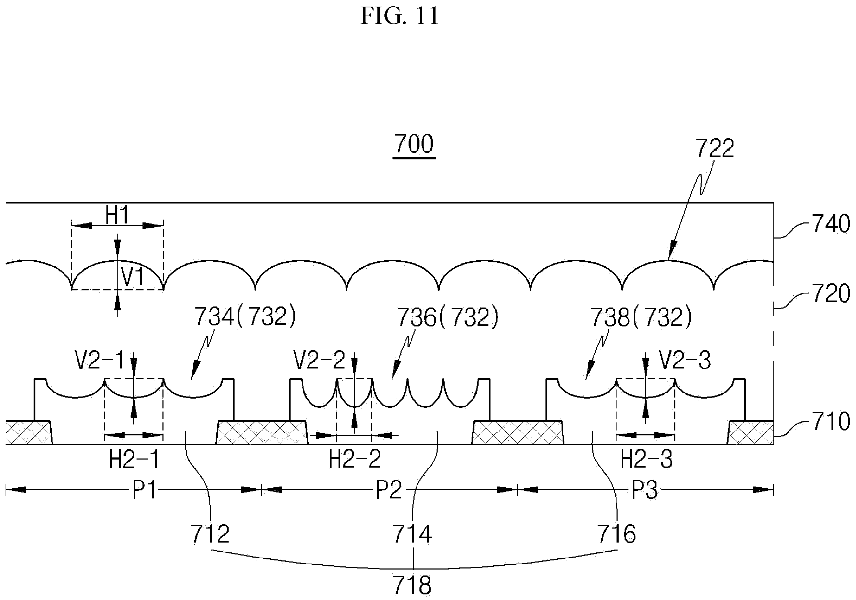

FIG. 11 is a schematic cross-sectional view illustrating a light emitting display device according to a seventh embodiment of the present disclosure.

As shown in FIG. 11, a light emitting display device 700 includes a substrate 601 (of FIG. 10) including a first pixel region P1, a second pixel region P2 and a third pixel region P3, a light emitting diode D (of FIG. 10) over the substrate 601, a convex lens 722 over the light emitting diode D and a concave lens 732 between the light emitting diode D and the convex lens 722.

The first pixel region P1 may be one of red, green and blue pixel regions, the second pixel region P2 may be another one of the red, green and blue pixel regions, and the third pixel region P3 may be the other one of the red, green and blue pixel regions. The substrate 301 may further include a fourth pixel region being a white pixel region.

In an aspect of the present disclosure, the first pixel region P1 may be the red pixel region, the second pixel region P2 may be the green pixel region, and the third pixel region P3 may be the blue pixel region.

For convenience of explanation, the configuration under the black matrix 710 and the color filter layer 718 are omitted.

For example, referring to FIG. 10, the TFT Tr including the semiconductor layer 610, the gate electrode 614, the source electrode 630 and the drain electrode 632 is formed on the substrate 601, and the light emitting diode D, which is electrically connected to the TFT Tr, is disposed over the TFT Tr.

In an aspect of the present disclosure, the light emitting diode D may emit the red light at the first pixel region P1, the green light at the second pixel region P2 and the blue light at the third pixel region P3.

Alternatively, the light emitting diode D may emit the white light at the first to third pixel regions P1, P2 and P3.

The encapsulating layer 650 is disposed over the light emitting diode D, and the touch electrode layer including the first and second touch electrodes 666 and 668 are disposed over the encapsulating layer 650.

Referring again to FIG. 10, a black matrix 710 and a color filter layer 718 may be formed on the encapsulating layer 650 or the touch electrode layer. The black matrix 710 may surround each of the first to third pixel regions P1, P2 and P3 and include an opening in correspondence to each of the first to third pixel regions P1, P2 and P3. The color filter layer 718 is formed the opening of the black matrix 710 to correspond to each of the first to third pixel regions P1, P2 and P3.

The color filter layer includes a first color filter pattern 712 corresponding to the first pixel region P1, a second color filter pattern 714 corresponding to the second pixel region P2 and a third color filter pattern 716 corresponding to the third pixel region P3. The first color filter pattern 712 is one of a red color filter pattern, a green color filter pattern and a blue color filter pattern, the second color filter pattern 714 is the other of the red color filter pattern, the green color filter patter, and the blue color filter pattern, and the third color filter pattern 716 is the remaining one of the red color filter pattern, the green color filter pattern and the blue color filter pattern. In an aspect of the present disclosure, the first color filter pattern 712 may be a red color filter pattern, the second color filter pattern 714 may be a green color filter pattern, and the third color filter pattern 716 may be a blue color filter pattern. That is, the first color filter pattern 712, the second color filter pattern 714 and the third color filter pattern 716 may be different from each other.

The concave lens 732 is disposed over the color filter layer 718. A plurality of concave lenses 732 are formed to correspond to the first to third pixel regions P1, P2 and P3. A portion of the color filter layer 718 may be etched to provide the plurality of concave lenses 732 on a upper surface of the color filter layer 718.

A convex lens 722 is disposed on the concave lens 732. A plurality of convex lenses 722 are formed to correspond to the first to third pixel regions P1, P2 and P3. For example, a first insulating layer 720 may be formed on the concave lens 732, and the convex lens 722 may be provided on a upper surface of the first insulating layer 720.

A second insulating layer 740 is formed on the convex lens 722. The second insulating layer 740 protects the convex lens 722 and provides a flat top surface.

A refractive index of each of the color filter layer 718 and the second insulating layer 740 may be greater than that of the first insulating layer 720. The refractive index of the color filter layer 718 and the refractive index of the second insulating layer 740 may be the same or different.

In an aspect of the present disclosure, the refractive index of the color filter layer 718 may be greater than the refractive index of the second insulating layer 740. A difference between the refractive index of the color filter layer 718 and the refractive index of the first insulating layer 720 may be 0.1 or less.

In an aspect of the present disclosure, the refractive index of the second insulating layer 740 may be greater than the refractive index of the color filter layer 718. A difference between the refractive index of the second insulating layer 740 and the refractive index of the first insulating layer 720 may be 0.1 or less.

In an aspect of the present disclosure, the refractive index of the color filter layer 718 may be equal to the refractive index of the second insulating layer 740. A difference between each of the refractive index of the color filter layer 718 and the refractive index of the third second insulating layer 740 and the refractive index of the first insulating layer 720 may be 0.1 or less.

In an aspect of the present disclosure, each of the refractive index of the color filter layer 718 and the refractive index of the second insulating layer 740 may have a range of 1.5 to 1.65, and the refractive index of the first insulating layer 720 may have a range of 1.45 to 1.55.

Each of the color filter layer 718, the first and second insulating layers 720 and 740 may be formed of an organic insulating material. For example, each of the color filter layer 718, the first and second insulating layers 720 and 740 may be formed of epoxy resin or photo-acryl.

The convex lens 722 and the concave lens 732 are alternately arranged. For example, each of the convex lens 722 and the concave lens 732 may have a honeycomb shape, but it is not limited thereto.

One end of at least one of the plurality of convex lenses 722 is positioned between both ends of the concave lens 732. In other words, a center of at least one of the plurality of convex lenses 722 is positioned between two centers of adjacent two concave lenses 732. Namely, at least one of the plurality of convex lenses 722 incompletely overlaps and partially overlaps the concave lens 732.

Each of the plurality of convex lenses 722 has a first vertical length (i.e., first depth) V1 and a first horizontal length (i.e., first width) H1. An aspect ratio (i.e., V1/H1) of the convex lenses 722 may have a range of 5% to 20%. The plurality of convex lenses 722 may have the same shape and size in the first to third pixel regions P1, P2 and P3.

The plurality of concave lenses 732 include a first concave lenses 734 corresponding to the first pixel region P2, a second concave lenses 736 corresponding to the second pixel region P2 and a third concave lenses 738 corresponding to the third pixel region P3.

Each of the first concave lenses 734 in the first pixel region P1 has a vertical length (i.e., depth) V2-1 and a horizontal length (i.e., width) H2-1. Each of the second concave lenses 736 in the second pixel region P2 has a vertical length V2-2 and a horizontal length H2-2. Each of the third concave lenses 738 in the third pixel region P3 has a vertical length V2-3 and a horizontal length H2-3.

Each of the first concave lenses 734 in the first pixel region P1 has a first aspect ratio (i.e., V2-1/H2-1). Each of the second concave lenses 736 in the second pixel region P2 has a second aspect ratio (i.e., V2-2/H2-2). Each of the third concave lenses 738 in the third pixel region P3 has a third aspect ratio (i.e., V2-3/H2-3).

The second aspect ratio (i.e., V2-1/H2-1) of the second concave lenses 736 is greater than each of the third aspect ratio (i.e., V2-3/H2-3) of the third concave lenses 738 and the first aspect ratio (i.e., V2-1/H2-1) of the first concave lenses 734.

In an aspect of the present disclosure, the depth (V2-2) of the second concave lenses 736 may be greater than the depth (V2-1) of the first concave lenses 734 and the depth (V2-3) of the third concave lenses 738.

In an aspect of the present disclosure, the width (H2-2) of the second concave lenses 736 may be smaller than the width (H2-1) of the first concave lenses 734 and the width (H2-3) of the third concave lenses 738.

In an aspect of the present disclosure, the depth (V2-2) of the second concave lenses 736 may be greater than the depth (V2-1) of the first concave lenses 734 and the depth (V2-3) of the third concave lenses 738, and the width (H2-2) of the second concave lenses 736 may be smaller than the width (H2-1) of the first concave lenses 734 and the width (H2-3) of the third concave lenses 738.

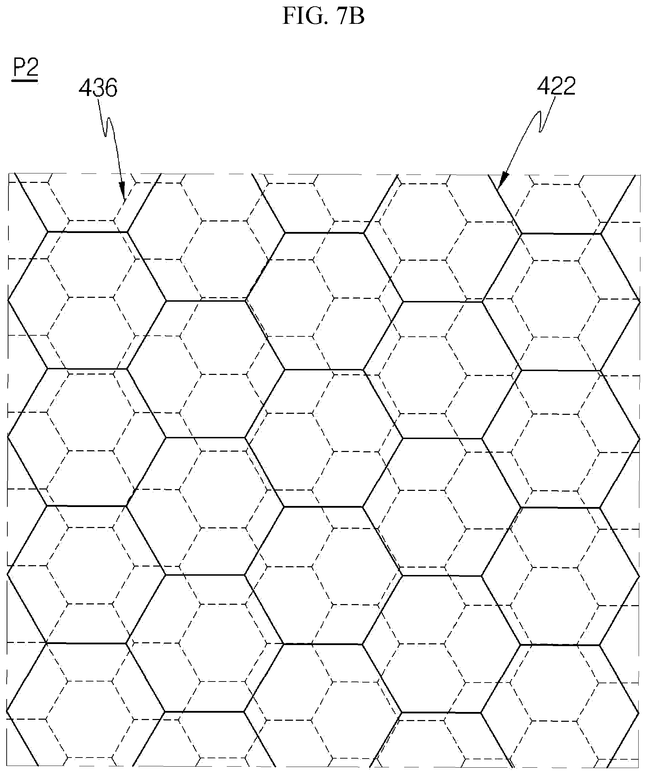

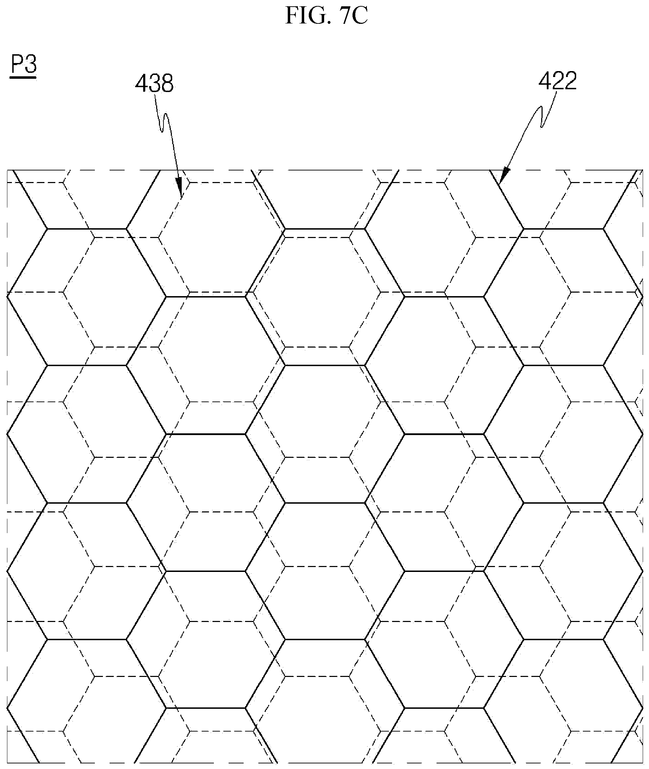

For example, the convex lens 722 and the first concave lens 734 in the first pixel region P1 may have a shape in a plan view shown in FIG. 7A, the convex lens 722 and the second concave lens 736 in the second pixel region P2 may have a shape in a plan view shown in FIG. 7B, and the convex lens 722 and the third concave lens 738 in the third pixel region P2 may have a shape in a plan view shown in FIG. 7C.

The first, second and third pixel regions P1, P2, P3 may be the red, green and blue pixel regions, respectively.

Since the reflectance in the green pixel region is greater than that of the red and blue pixel regions, the second aspect ratio (i.e., V2-2/H2-2) of the second concave lenses 736 is greater than each of the third aspect ratio (i.e., V2-3/H2-3) of the third concave lenses 738 and the first aspect ratio (i.e., V2-1/H2-1) of the first concave lenses 734 so that the reflectance difference in the first to third pixel regions P1, P2 and P3 can be compensated.

The first aspect ratio (i.e., V2-1/H2-1) of the first concave lenses 734 and the third aspect ratio (i.e., V2-3/H2-3) of the third concave lenses 738 may be the same or different. In an aspect of the present disclosure, the first aspect ratio (i.e., V2-1/H2-1) of the first concave lenses 734 may be equal to or greater than the third aspect ratio (i.e., V2-3/H2-3) of the third concave lenses 738.

In the light emitting display device 700 according to the seventh embodiment of the present disclosure, the light from the light emitting diode D passes through the color filter layer 718, the concave lens 732, the first insulating layer 720, the convex lens 722 and the second insulating layer 740 so that an image can be displayed at a surface of the second insulating layer 740.

The light emitting display device 700 includes a color filter layer 718 on or over the encapsulation layer 650 without a polarization plate so that an ambient light reflection can be reduced. Namely, in the light emitting display device 700, the brightness decrease by the polarization plate can be minimized or reduced, and the display quality decrease by an ambient light reflection can be prevented.

In addition, without the convex lens 722 and concave lens 732, an ambient light diffraction mura may be occurred by a step difference generated by the TFT Tr. The ambient light diffraction may be intensified by the color filter layer 718 so that a rainbow mura may be occurred by an interference between adjacent pixel regions P. However, the light emitting display device 700 of the present disclosure includes the convex lens 722 and concave lens 732, which are alternately arranged over the color filter layer 718, so that the ambient light diffraction mura and/or the rainbow mura may be minimized or prevented or reduced. Namely, the light may be dispersed or scattered by the convex lens 722 and concave lens 732 so that the ambient light diffraction mura and/or the rainbow mura may be minimized or prevented or reduced.

Moreover, since the concave lenses 732 in the second pixel region P2, which has a relatively high reflectance, is relatively large, the reflectance difference between pixel regions P can be compensated.

Furthermore, since the concave lens 732 is provided on the upper surface of the color filter layer 718 without an additional insulating layer, e.g., the first insulating layer 430 (of FIG. 4), the light emitting display device 700 may have a simple structure and low production cost.

Accordingly, in the light emitting display device 700 according to the seventh embodiment of the present disclosure, without the brightness decrease, the ambient light diffraction mura and the rainbow mura and moiré pattern, the ambient light reflection can be prevented, and high-quality image can be provided.

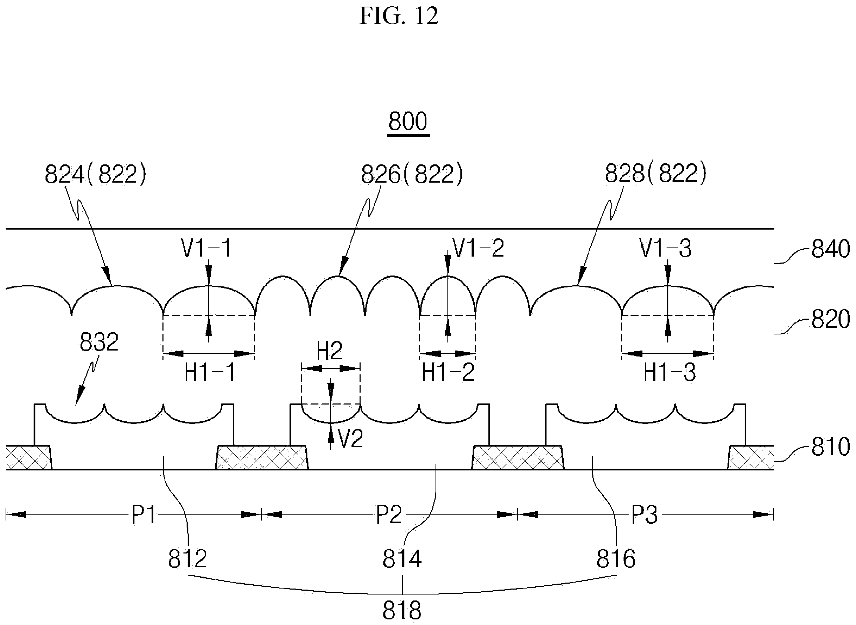

FIG. 12 is a schematic cross-sectional view illustrating a light emitting display device according to an eighth embodiment of the present disclosure.

As shown in FIG. 12, a light emitting display device 800 includes a substrate 601 (of FIG. 10) including a first pixel region P1, a second pixel region P2 and a third pixel region P3, a light emitting diode D (of FIG. 10) over the substrate 601, a convex lens 822 over the light emitting diode D and a concave lens 832 between the light emitting diode D and the convex lens 822.

The first pixel region P1 may be one of red, green and blue pixel regions, the second pixel region P2 may be another one of the red, green and blue pixel regions, and the third pixel region P3 may be the other one of the red, green and blue pixel regions. The substrate 301 may further include a fourth pixel region being a white pixel region.

In an aspect of the present disclosure, the first pixel region P1 may be the red pixel region, the second pixel region P2 may be the green pixel region, and the third pixel region P3 may be the blue pixel region.

For convenience of explanation, the configuration under the black matrix 810 and the color filter layer 818 are omitted.

For example, referring to FIG. 10, the TFT Tr including the semiconductor layer 610, the gate electrode 614, the source electrode 630 and the drain electrode 632 is formed on the substrate 601, and the light emitting diode D, which is electrically connected to the TFT Tr, is disposed over the TFT Tr.

In an aspect of the present disclosure, the light emitting diode D may emit the red light at the first pixel region P1, the green light at the second pixel region P2 and the blue light at the third pixel region P3.

Alternatively, the light emitting diode D may emit the white light at the first to third pixel regions P1, P2 and P3.

The encapsulating layer 650 is disposed over the light emitting diode D, and the touch electrode layer including the first and second touch electrodes 666 and 668 are disposed over the encapsulating layer 650.

Referring again to FIG. 12, a black matrix 810 and a color filter layer 818 may be formed on the encapsulating layer 650 or the touch electrode layer. The black matrix 810 may surround each of the first to third pixel regions P1, P2 and P3 and include an opening in correspondence to each of the first to third pixel regions P1, P2 and P3. The color filter layer 818 is formed the opening of the black matrix 810 to correspond to each of the first to third pixel regions P1, P2 and P3.

The color filter layer includes a first color filter pattern 812 corresponding to the first pixel region P1, a second color filter pattern 814 corresponding to the second pixel region P2 and a third color filter pattern 816 corresponding to the third pixel region P3. The first color filter pattern 812 is one of a red color filter pattern, a green color filter pattern and a blue color filter pattern, the second color filter pattern 814 is the other of the red color filter pattern, the green color filter patter, and the blue color filter pattern, and the third color filter pattern 816 is the remaining one of the red color filter pattern, the green color filter pattern and the blue color filter pattern. In an aspect of the present disclosure, the first color filter pattern 812 may be a red color filter pattern, the second color filter pattern 814 may be a green color filter pattern, and the third color filter pattern 816 may be a blue color filter pattern. That is, the first color filter pattern 812, the second color filter pattern 814 and the third color filter pattern 816 may be different from each other.

The concave lens 832 is disposed over the color filter layer 818. A plurality of concave lenses 832 are formed to correspond to the first to third pixel regions P1, P2 and P3. A portion of the color filter layer 818 may be etched to provide the plurality of concave lenses 832 on a upper surface of the color filter layer 818.

A convex lens 822 is disposed on the concave lens 832. A plurality of convex lenses 822 are formed to correspond to the first to third pixel regions P1, P2 and P3. For example, a first insulating layer 820 may be formed on the concave lens 832, and the convex lens 822 may be provided on a upper surface of the first insulating layer 820.

A second insulating layer 840 is formed on the convex lens 822. The second insulating layer 840 protects the convex lens 822 and provides a flat top surface.

A refractive index of each of the color filter layer 818 and the second insulating layer 840 may be greater than that of the first insulating layer 820. The refractive index of the color filter layer 818 and the refractive index of the second insulating layer 840 may be the same or different.

In an aspect of the present disclosure, the refractive index of the color filter layer 818 may be greater than the refractive index of the second insulating layer 840. A difference between the refractive index of the color filter layer 818 and the refractive index of the first insulating layer 820 may be 0.1 or less.

In an aspect of the present disclosure, the refractive index of the second insulating layer 840 may be greater than the refractive index of the color filter layer 818. A difference between the refractive index of the second insulating layer 840 and the refractive index of the first insulating layer 820 may be 0.1 or less.

In an aspect of the present disclosure, the refractive index of the color filter layer 818 may be equal to the refractive index of the second insulating layer 840. A difference between each of the refractive index of the color filter layer 818 and the refractive index of the third second insulating layer 840 and the refractive index of the first insulating layer 820 may be 0.1 or less.

In an aspect of the present disclosure, each of the refractive index of the color filter layer 818 and the refractive index of the second insulating layer 840 may have a range of 1.5 to 1.65, and the refractive index of the first insulating layer 820 may have a range of 1.45 to 1.55.

Each of the color filter layer 818, the first and second insulating layers 820 and 840 may be formed of an organic insulating material. For example, each of the color filter layer 818, the first and second insulating layers 820 and 840 may be formed of epoxy resin or photo-acryl.

Each of the color filter layer 818, the first and second insulating layers 820 and 840 may be formed of an organic insulating material. For example, each of the color filter layer 818, the first and second insulating layers 820 and 840 may be formed of epoxy resin or photo-acryl.

The convex lens 822 and the concave lens 832 are alternately arranged. For example, each of the convex lens 822 and the concave lens 832 may have a honeycomb shape, but it is not limited thereto.

One end of at least one of the plurality of convex lenses 822 is positioned between both ends of the concave lens 832. In other words, a center of at least one of the plurality of convex lenses 822 is positioned between two centers of adjacent two concave lenses 832. Namely, at least one of the plurality of convex lenses 822 incompletely overlaps and partially overlaps the concave lens 832.

Each of the plurality of convex lenses 822 has a second vertical length (i.e., second depth) V2 and a second horizontal length (i.e., second width) H2. An aspect ratio (i.e., V2/H2) of the convex lenses 822 may have a range of 5% to 20%. The plurality of convex lenses 822 may have the same shape and size in the first to third pixel regions P1, P2 and P3.

The plurality of convex lenses 822 include a first convex lenses 824 corresponding to the first pixel region P2, a second convex lenses 826 corresponding to the second pixel region P2 and a third concave lenses 838 corresponding to the third pixel region P3.

Each of the first convex lenses 824 in the first pixel region P1 has a vertical length (i.e., depth) V1-1 and a horizontal length (i.e., width) H1-1. Each of the second convex lenses 826 in the second pixel region P2 has a vertical length V1-2 and a horizontal length H1-2. Each of the third convex lenses 828 in the third pixel region P3 has a vertical length V1-3 and a horizontal length H1-3.

Each of the first convex lenses 824 in the first pixel region P1 has a first aspect ratio (i.e., V1-1/H1-1). Each of the second convex lenses 826 in the second pixel region P2 has a second aspect ratio (i.e., V1-2/H1-2). Each of the third convex lenses 828 in the third pixel region P3 has a third aspect ratio (i.e., V1-3/H1-3).

The second aspect ratio (i.e., V1-1/H1-1) of the second convex lenses 826 is greater than each of the third aspect ratio (i.e., V1-3/H1-3) of the third convex lenses 828 and the first aspect ratio (i.e., V1-1/H1-1) of the first convex lenses 824.

In an aspect of the present disclosure, the depth (V1-2) of the second convex lenses 826 may be greater than the depth (V1-1) of the first convex lenses 824 and the depth (V1-3) of the third convex lenses 828.

In an aspect of the present disclosure, the width (H1-2) of the second convex lenses 826 may be smaller than the width (H1-1) of the first convex lenses 824 and the width (H1-3) of the third convex lenses 828.

In an aspect of the present disclosure, the depth (V1-2) of the second convex lenses 826 may be greater than the depth (V1-1) of the first convex lenses 824 and the depth (V1-3) of the third convex lenses 828, and the width (H1-2) of the second convex lenses 826 may be smaller than the width (H1-1) of the first convex lenses 824 and the width (H1-3) of the third concave lenses 838.

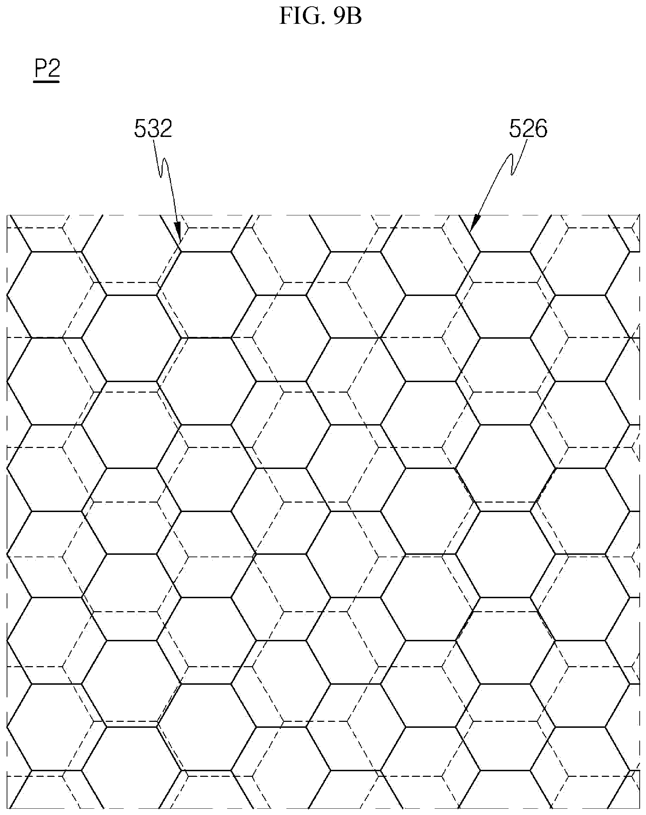

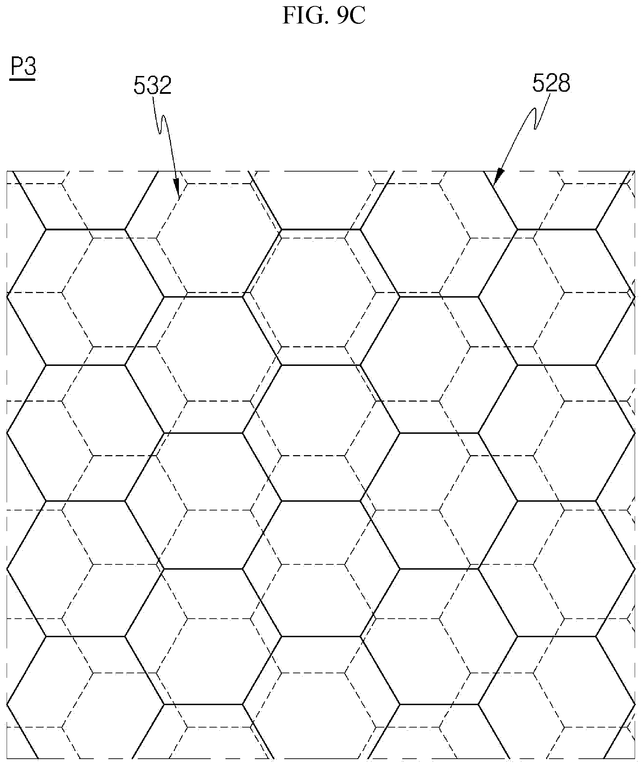

For example, the concave lenses 832 and the first convex lenses 824 in the first pixel region P1 may have a shape in a plan view shown in FIG. 9A, the concave lenses 832 and the second convex lenses 826 in the second pixel region P2 may have a shape in a plan view shown in FIG. 9B, and the concave lenses 832 and the third convex lenses 828 in the third pixel region P2 may have a shape in a plan view shown in FIG. 9C.

The first, second and third pixel regions P1, P2, P3 may be the red, green and blue pixel regions, respectively.

Since the reflectance in the green pixel region is greater than that of the red and blue pixel regions, the second aspect ratio (i.e., V1-2/H1-2) of the second convex lenses 826 is greater than each of the third aspect ratio (i.e., V1-3/H1-3) of the third convex lenses 828 and the first aspect ratio (i.e., V1-1/H1-1) of the first convex lenses 824 so that the reflectance difference in the first to third pixel regions P1, P2 and P3 can be compensated.

The first aspect ratio (i.e., V1-1/H1-1) of the first convex lenses 824 and the third aspect ratio (i.e., V1-3/H1-3) of the third convex lenses 828 may be the same or different. In an aspect of the present disclosure, the first aspect ratio (i.e., V1-1/H1-1) of the first convex lenses 824 may be equal to or greater than the third aspect ratio (i.e., V1-3/H1-3) of the third convex lenses 828.

In the light emitting display device 800 according to the eighth embodiment of the present disclosure, the light from the light emitting diode D passes through the color filter layer 818, the concave lens 832, the first insulating layer 820, the convex lens 822 and the second insulating layer 840 so that an image can be displayed at a surface of the second insulating layer 840.

The light emitting display device 800 includes a color filter layer 818 on or over the encapsulation layer 650 without a polarization plate so that an ambient light reflection can be reduced. Namely, in the light emitting display device 800, the brightness decrease by the polarization plate can be minimized or reduced, and the display quality decrease by an ambient light reflection can be prevented.

In addition, without the convex lens 822 and concave lens 832, an ambient light diffraction mura may occur by a step difference generated by the TFT Tr. The ambient light diffraction may be intensified by the color filter layer 818 so that a rainbow mura may occur by an interference between adjacent pixel regions P. However, the light emitting display device 800 of the present disclosure includes the convex lens 822 and concave lens 832, which are alternately arranged over the color filter layer 818, so that the ambient light diffraction mura and/or the rainbow mura may be minimized or prevented or reduced. Namely, the light may be dispersed or scattered by the convex lens 822 and concave lens 832 so that the ambient light diffraction mura and/or the rainbow mura may be minimized or prevented or reduced.

Moreover, since the convex lenses 822 in the second pixel region P2, which has a relatively high reflectance, is relatively large, the reflectance difference between pixel regions P can be compensated.

Furthermore, since the concave lens 832 is provided on the upper surface of the color filter layer 818 without an additional insulating layer, e.g., the first insulating layer 430 (of FIG. 4), the light emitting display device 800 may have a simple structure and low production cost.

Accordingly, in the light emitting display device 800 according to the eighth embodiment of the present disclosure, without the brightness decrease, the ambient light diffraction mura and the rainbow mura and moiré pattern, the ambient light reflection can be prevented, and high-quality image can be provided.

As described above, in the light emitting display device of the present disclosure, a convex lens is provided over the light emitting diode, and a concave lens, which is alternately arranged with the convex lens, is provided between the light emitting diode and the convex lens. In this case, the concave lens is provide on an additional insulating layer or a color filter layer. In the light emitting display device of the present disclosure, without the brightness decrease, the ambient light diffraction mura and the rainbow mura and moiré pattern, the ambient light reflection can be prevented, and high-quality image can be provided.

It will be apparent to those skilled in the art that various modifications and variations can be made in the embodiments of the present disclosure. Thus, it is intended that the modifications and variations cover this disclosure provided they come within the scope of the appended claims.

## Claims

1. A light emitting display device (100, 200, 300, 400, 500, 600, 700, 800), comprising:
a substrate (101, 201, 301, 601);
a light emitting diode (D) on the substrate (101, 201, 301, 601);
a bank (146, 246, 346, 646) surrounding the light emitting diode (D);
a thin film transistor (Tr) between the substrate (101, 201, 301, 601) and the light emitting diode (D);
an encapsulation layer (150, 250, 350, 650) on the light emitting diode (D);
a color filter layer (172, 272, 372, 418, 518, 672, 718, 818) on the encapsulation layer (150, 250, 350, 650) and corresponding to the light emitting diode (D);
a convex lens (182, 282, 382, 422, 522, 682, 722, 822) on the color filter layer (172, 272, 372, 418, 518, 672, 718, 818); and
a touch electrode layer (166, 168, 266, 268, 366, 368, 666, 668) between the encapsulation layer (150, 250, 350, 650) and the convex lens (182, 282, 382, 422, 522, 682, 722, 822).

2. The light emitting display device (100) according to claim 1, wherein the convex lens (182) is disposed only on the color filter layer (172).

3. The light emitting display device (100) according to claim 1, wherein the convex lens (182) has a planar area being same as a planar area of the color filter layer (172).

4. The light emitting display device (100) according to claim 1, further comprising:
a first insulating layer (180) covering the color filter layer (172),
wherein the convex lens (182) is provided on a surface of the first insulating layer (180).

5. The light emitting display device (100) according to claim 4, wherein the convex lens (182) corresponds to the color filter layer (172), and the first insulating layer (180) has an even top surface outside the color filter layer (172).

6. The light emitting display device (100) according to claim 5, further comprising:
a second insulating layer (174) on the first insulating layer (180),
wherein the second insulating layer (174) has a first thickness in correspondence to the convex lens (182) and a second thickness in correspondence to the even top surface of the color filter layer (172), and
wherein the second thickness is greater than the first thickness.

7. The light emitting display device (100) according to claim 1, further comprising:
a black matrix (170) at a boundary of a pixel region (P) of the substrate (101),
wherein an end of the color filter layer (172) and an end of the convex lens (182) are disposed on an end of the black matrix (170).

8. The light emitting display device (100, 200, 300, 400, 500, 600, 700, 800) according to claim 1, wherein the light emitting display device (100) is a foldable display device.

9. The light emitting display device (100, 200, 300, 400, 500, 600, 700, 800) according to claim 1, wherein the bank (146, 246, 346, 646) includes a light-absorbing particle.

10. The light emitting display device (100, 200, 300, 400, 500, 600, 700, 800) according to claim 9, wherein the light-absorbing particle comprises one of carbon black, carbon nano tube (CNT) and graphene.

11. The light emitting display device (300, 400, 500, 600, 700, 800) according to claim 1, further comprising:
a concave lens (392, 432, 532, 674, 732, 832) between the light emitting diode (D) and the convex lens(382, 422, 522, 682, 722, 822),
wherein an end of the convex lens (382, 422, 522, 682, 722, 822) is positioned between both ends of the concave lens (392, 432, 532, 674, 732, 832).

12. The light emitting display device (300, 400, 500) according to claim 11, further comprising:
a first insulating layer (390, 430, 530) covering the color filter layer (372, 418, 518);
a second insulating layer (380, 420, 520) covering the first insulating layer (390, 430, 530); and
a third insulating layer (374, 440, 540) on the convex lens (382 422, 522),
wherein the concave lens (392, 432, 532) is provided on a surface of the first insulating layer (390, 430, 530), and
wherein the convex lens (382, 422, 522) is provided on a surface of the second insulating layer (380, 420, 520).

13. The light emitting display device (600, 700, 800) according to claim 11, further comprising:
a second insulating layer (680, 720, 820) covering the concave lens (674, 732, 832); and
a third insulating layer (690, 740, 840) on the convex lens (682 722, 822),
wherein the concave lens (674, 732, 832) is provided on a surface of the color filter layer (672, 718, 818), and
wherein the convex lens (682 722, 822)is provided on a surface of the second insulating layer (680, 720, 820).

14. The light emitting display device (400, 700) according to claim 11, comprising a first pixel region (P1), a second pixel region (P2), and a third pixel region (P3),
wherein the concave lens (432, 732) includes a first concave lens (434, 734) in the first pixel region (P1), a second concave lens (436, 736) in the second pixel region (P2), and a third concave lens (438, 738) in the third pixel region (P3),
wherein a ratio of a first depth (V2-1) to a first width (H2-1) in the first concave lens (434, 734) is smaller than a ratio of a second depth (V2-2) to a second width (H2-2) in the second concave lens (436, 736),
wherein a ratio of a third depth (V2-3) to a third width (H2-3) in the third concave lens (738) is smaller than the ratio of the second depth (V2-2) to the second width (H2-2) in the second concave lens (436, 736), and
wherein the ratio of the third depth (V2-3) to the third width (H2-3) in the third concave lens (438) is equal to or smaller than the ratio of the first depth (V2-1) to the first width (H2-1) in the first concave lens (434, 734).

15. The light emitting display device (500, 800) according to claim 11, comprising a first pixel region (P1), a second pixel region (P2), and a third pixel region (P3),
wherein the convex lens (522, 822) includes a first convex lens (524, 824) in the first pixel region (P1), a second convex lens (526, 826) in the second pixel region (P2), and a third convex lens (528, 828) in the third pixel region (P3),
wherein a ratio of a first depth (V1-1) to a first width (H1-1) in the first convex lens (524, 824) is smaller than a ratio of a second depth (V1-2) to a second width (H1-2) in the second convex lens (526, 826),
wherein a ratio of a third depth (V1-3) to a third width (H1-3) in the third convex lens (528, 828) is smaller than the ratio of the second depth (V1-2) to the second width (H1-2) in the second convex lens (526, 826), and
wherein the ratio of the third depth (V1-3) to the third width (H1-3) in the third convex lens (528, 828) is equal to or smaller than the ratio of the first depth (V1-1) to the first width (H1-1) in the first convex lens (524, 824).
